# EUROPEAN PATENT APPLICATION

(11) **EP 1 065 789 A2**
(43) Date of publication of application: **03.01.2001**
(21) Application number: 99308291.6
(22) Date of filing: 20.10.1999
(51) Int. Cl.: H03M 13/15

(54) **Configurable Reed-Solomon encoder**

(30) Priority: 20.10.1998 JP 29889598
(71) Applicant: TEXAS INSTRUMENTS INC., Dallas, Texas 75243 (US)
(72) Inventor: Okita, Shigeru, Tokyo 141-0031 (JP)
(74) Representative: Potter, Julian Mark

(57) **Abstract**

Versatile Reed Solomon encoding equipment configurable for encoding the data of various Galois fields comprising:
- an input side transformation circuit (116) that transforms the input encoding target data (S250) into the data of a prescribed Galois field, on the basis of Galois field transformation parameter (S120a),
- a RS encoding/decoding core section (112) that performs the encoding process by the Galois field before the transformation mentioned previously, in regard to the transformed encoding target data mentioned above,
- an output side transformation circuit (119) that reversibly transforms the encoded data mentioned above into the data of the Galois field before the transformation on the basis of the Galois field transformation (S120b),
- and a Parameter setting section (120) that outputs the Galois field transformation parameters (S120a) and (S120b).

## Description

### [The scope of the patent application]

### [Case 1 of the application]

Reed Solomon encoding equipment which has:
-the first Galois field transformation system that transforms the input encoding target data into the specified Galois field data, on the basis of the first input Galois field transformation parameters,
-the encoding system that performs the encoding process with the transformed encoding target data mentioned above, by the Galois field that has finished the transformation as mentioned above,
-the second Galois field transformation method that performs the reverse transformation on the previously mentioned encoded data into the above-mentioned Galois field data as it was before the transformation, on the basis of the second input Galois field transformation parameters,
-and the parameter output method which outputs the first Galois field transformation parameter mentioned above and the second Galois field transformation parameters,
   with regard to the Reed Solomon encoding equipment which corresponds to the multiple RS (Reed Solomon) code that uses the different field formation polynomial expression, input encoding target data.

### [Case 2 of the application]

The encoding system mentioned above is the Reed Solomon encoding equipment that is described in Case 1 of the application, having a multiplier that corresponds to the transformed Galois field mentioned above.

### [Case 3 of the application]

The Reed Solomon encoding equipment described in Case 1 of the application, which has the following characteristics:
-The multiple RS codes mentioned above are the RSa code and RSb code that use the distinct field formation polynomial expression and each encoding symbol is Galois field GFₐ (2^{m}) and GF_{b} (2^{m}) having been extended on the basis of the m-th formation polynomial expressions Gpₐ (x) and Gp_{b} (x) respectively, which are on the Galois field GF (2) and distinct from each other.
-In regard to α that is the root of Gpₐ (x) mentioned above and the primitive polynomial GFₐ (2^{m}) mentioned above, and β that is the root of Gp_{b} (x) mentioned above and the primitive polynomial GF_{b}(2^{m}) mentioned above, Equation (1) shown below is resolved.
-The RSb code mentioned above is the symbol rectification and its code formation polynomial expression G_{cb}(x) is shown in Equation (2).
-When the input encoding target data mentioned above is encoded by the previously mentioned RSb code, the first Galois field transformation method mentioned above transforms the input encoding target data mentioned above into the data of the Galois field GFₐ(2^{m}) mentioned above from the Galois field GF_{b}(2^{m}) mentioned above.
-And the encoding system mentioned above performs the encoding, according to Equation (3) shown below which is the polynomial expression that transforms the code formation polynomial expression G_{cb} (x) mentioned above into the Galois field GFₐ (2^{m}) mentioned above.
-The second Galois field transformation system mentioned above performs the reverse transformation of the encoded data mentioned earlier from the previously mentioned Galois field GFₐ(2^{m}) into the Galois field GF_{b}(2^{m}) mentioned above.

### [Equation 1]

${\text{Gp}}_{\text{b}} {\text{(α}}^{\text{p}} \text{)=0}$

### [Equation 2]

${\text{G}}_{\text{cb}} \text{(x)=} \text{j} \text{=0} \text{L} {\text{(x+β}}^{\text{q(b+j)}} \text{)} \text{, L=2t- 1, or 2t}$

### [Equation 3]

${\text{G}}_{\text{cba}} \text{(x)=} \text{j} \text{=0} \text{L} {\text{(x+α}}^{\text{pq(b+j)}} \text{)} \text{, L=2t-1, or 2t}$

### [Case 4 of the application]

The first Galois field transformation method is the Reed Solomon encoding equipment described in Case 1 of the application, which has the following characteristics:
In the case that the number m among relations between 2^{m,}s input and output expresses the transverse matrix in the form of (---)^{T},
-in regard to the input (00---0001)^{T} of m bit, the output A1 = (00---001)^{T} of m bit is produced,
-in regard to the input (00---0010)^{T} of m bit, the output A1 = (A1, m-1, A1, m-2, --- A1, 0)^{T} of m bit is produced,
-in regard to the input (00---0100)^{T} of m bit, the output A2 = (A2, m-1, A2, m-2, --- A2, 0)^{T} of m bit is produced,
-in regard to the input (01---0000)^{T} of m bit, the output A m-2 = (A m-2, m-1, A m-2, m-2, --- A m-2, 0)^{T} of m bit is produced,
-in regard to the input (10---0000)^{T} of m bit, the output A m-1 = (A m-1, m-1, A m-1,m-2, ---A m-1, 0)^{T} of m bit is produced,
-and when the m×m matrix |Hba| is regulated with the Equation (4) as shown below,
   in regard to the input data D_{b-in} of m bit which was mentioned above, the arithmetic process is performed according to the Equation (5) shown below, and forms the output data Dₐ₋ₒᵤₜ of m bit.

### [Equation 4]

$\text{|Hba|=(A m-1 A m-2 --- A2 A1 A0)}$

### [Equation 5]

${\text{Da-out = |Hba| × D}}_{\text{b_in}}$

### [Case 5 of the application]

The parameter output system mentioned above is the Reed Solomon encoding equipment that is described in Case 4 of the application, which outputs the matrix |Hba| mentioned above, as the first Galois field transformation parameters mentioned above.

### [Case 6 of the application]

The parameter output system mentioned above outputs each line of the matrix |Hba| mentioned above, in appropriate sequence line by line, to the first Galois field transformation system, as the first Galois field transformation parameters,
and the first Galois field transformation system mentioned above is the Reed Solomon encoding equipment that is described in Case 5 of the application,
-which inputs the bit data that corresponds to the previously mentioned matrix s line that was input as the first Galois field transformation parameter, from the first input terminal,
-which inputs the bit data that corresponds to the input encoding target data mentioned above, from the second input terminal,
   and this Reed Solomon encoding equipment employs the following method:
-The multiple logical conjunction arithmetic method of the number that corresponds to the bit data mentioned earlier, which performs the arithmetic for the logical conjunction between the bit data that was input from the first input terminal mentioned previously and the bit data that was input from the second input terminal mentioned above.
-And the exclusive logical disjunction arithmetic method that performs the arithmetic for the exclusive logical disjunction of the arithmetic result of the multiple logical conjunction arithmetic process mentioned above.

### [Case 7 of the application]

The second Galois field transformation system mentioned above is the Reed Solomon encoding equipment that is described in Case 4 of the application, which forms m bit of output data D_{b-out} by performing the arithmetic process according to Equation (6) shown below, in the case that the reverse matrix of the previously described matrix |*H*_{*ba*}| is set as |*H*_{*ab*}|.

### [Equation 6]

${\text{D}}_{\text{b_out}} \text{=|} {\text{H}}_{\text{ab}} {\text{| × D}}_{\text{a_in}}$

### [Case 8 of the application]

The parameter output system mentioned above is the Reed Solomon encoding equipment that is described in the Case 7 of the application, which outputs the previously described matrix |*H*_{*ab*}| to the second Galois field transformation system mentioned before, as the second Galois field transformation parameter.

### [Case 9 of the application]

The parameter output process mentioned above outputs each line of the matrix |*H*_{*ab*}| mentioned above, in appropriate sequence line by line, to the second Galois field transformation system, as the second Galois field transformation parameter,
and the second Galois field transformation system mentioned above is the Reed Solomon encoding equipment that is described in Case 8 of the application.
-which inputs the bit data that corresponds to the previously mentioned matrix |*H*_{*ab*}|'s line that was input as the second Galois field transformation parameters, from the first input terminal,
-which inputs the bit data that corresponds to the encoded data mentioned above, from the second input terminal,
   and this Reed Solomon encoding equipment employs the following method:
-The multiple logical conjunction arithmetic system of the number that corresponds to the bit data mentioned earlier, which performs the arithmetic for the logical conjunction between the bit data that was input from the first input terminal mentioned previously and the bit data that was input from the second input terminal mentioned above.
-And the exclusive logical disjunction arithmetic process that performs the arithmetic for the exclusive logical disjunction of the arithmetic results of the multiple logical conjunction arithmetic process mentioned above.

### [Case 10 of the application]

The Reed Solomon encoding equipment that is described in Case 1 of the application,
-which also has a multiplier coefficient memory system,
-and where the parameter data mentioned above supply the multiplier coefficient that has been memorised in the multiplier coefficient memory system mentioned above, to the previously mentioned multiplier.

### [Case 11 of the application]

The Reed Solomon decoding equipment which has:
-the first Galois field transformation method that transforms the input decoding target data into the specified Galois field data, on the basis of the first input Galois field transformation parameters,
-the decoding system that performs the decoding process to the transformed decoding target data mentioned above, by the Galois field that has finished the transformation as mentioned above,
-the second Galois field transformation system that performs the reverse transformation of the previously mentioned decoded data into the above-mentioned Galois field data as it was before the transformation, on the basis of the second input Galois field transformation parameters,
-and the parameter output system which outputs the first Galois field transformation parameters mentioned above and the second Galois field transformation parameters,
   with regard to the Reed Solomon decoding equipment which corresponds to the multiple RS code that uses the different field formation polynomial expression, input encoding target data.

### [Case 12 of the application]

The decoding device mentioned above is the Reed Solomon decoding equipment that is described in Case 11 of the application, which has a multiplier that corresponds to the transformed Galois field mentioned above.

### [Case 13 of the application]

The Reed Solomon decoding equipment described in Case 11 of the application, which has the following characteristics:
-The multiple RS codes mentioned above are the RSa code and RSb code that use the distinct field formation polynomial expression and each encoding symbol is Galois field GFₐ(2^{m}) and GF_{b}(2^{m}) that have been extended on the basis of m-th formation polynomial expression GPₐ(x) and Gp_{b}(x) respectively, which are on the Galois field GF (2) and distinct from each other.
-In regard to α that is the root of Gpₐ(x) mentioned above and the primitive polynomial GFₐ(2^{m}) mentioned above, and β that is the root of Gp_{b}(x) mentioned above and the primitive polynomial GF_{b}(2^{m}) mentioned above, Equation (7) shown below is concluded.
-The RSb code mentioned above represents the symbol rectification and its code formation polynomial expression G_{cb}(x) is shown in Equation (8).
-When the input decoding target data is decoded, the first Galois field transformation system mentioned above transforms the decoding target data mentioned above into the data of Galois field GFₐ(2^{m}) mentioned above from Galois field GF_{b}(2^{m}) mentioned above.
-And the decoding device mentioned above performs the decoding, according to Equation (9) shown below which is the polynomial expression that transforms the code formation polynomial expression G_{cb}(x) mentioned above into the Galois field GFₐ(2^{m}) mentioned above.
-The second Galois field transformation device mentioned above performs the reverse transformation of the decoded data mentioned before from the previously mentioned Galois field GFₐ(2^{m}) into the Galois field GF_{b}(2^{m}) mentioned above.

### [Equation 7]

${\text{Gp}}_{\text{b}} {\text{(α}}^{\text{p}} \text{) = 0}$

### [Equation 8]

${\text{G}}_{\text{cb}} \text{(x)=} \text{j} \text{=0} \text{L} {\text{(x+β}}^{\text{q(b+j)}} \text{)} \text{, L=2t-1, or 2 t}$

### [Equation 9]

${\text{G}}_{\text{cba}} \text{(x)=} \text{j} \text{=0} \text{L} {\text{(x+α}}^{\text{pq(b+j)}} \text{)} \text{, L=2t-1, or 2t}$

### [Case 14 of the application]

The first Galois field transformation device is the Reed Solomon decoding equipment described in Case 11 of the application, which has the following characteristics:
In the case that the number of m among the relations between 2^{m}'s input and output expresses the transverse matrix in the form of (---)^{T},
-in regard to the input (00---0001)^{T} of m bit, the output A1 = (00---001)^{T} of m bit is performed,
-in regard to the input (00---0010)^{T} of m bit, the output A1 = (A1, m-1, A1, m-2, --- A1, 0)^{T} of m bit is produced,
-in regard to the input (00---0100)^{T} of m bit, the output A2 = (A2, m-1, A2, m-2, --- A2, 0)^{T} of m bit is produced,
-in regard to the input (01--0000)^{T} of m bit, the output A m-2 = (A m-2, m-1, A m-2, m-2, --- A m-2, 0)^{T} of m bit is produced,
-in regard to the input (10---0000)^{T} of m bit, the output A m-1 = (A m-1, m-1, A m-1, m-2, --- A m-1, 0)^{T} of m bit is produced,
-and when the m × m matrix |*H*_{*ba*}| is regulated with Equation (10) as shown below,
   in regard to the input data D_{b-in} of m bit which was mentioned above, the arithmetic process is performed according to Equation (11) shown below, and forms the output data Dₐ₋ₒᵤₜ of m bit.

### [Equation 10]

$\text{|} {\text{H}}_{\text{ba}} \text{| = (A m-1 A m-2 --- A2 A1 A0)}$

### [Equation 11]

${\text{D}}_{\text{a_out}} \text{= |} {\text{H}}_{\text{ba}} {\text{| × D}}_{\text{b_in}}$

### [Case 15 of the application]

The parameter output device mentioned above is the Reed Solomon decoding equipment that is described in Case 14 of the application, which outputs the matrix [Hba] mentioned above, as the first Galois field transformation parameter mentioned above.

### [Case 16 of the application]

The parameter output device mentioned above outputs each line of the matrix [Hba] mentioned above, in due sequence line by line, to the first Galois field transformation devicw, as the first Galois field transformation parameters,
and the first Galois field transformation system mentioned above is the Reed Solomon decoding equipment that is described in Case 15 of the application,
-which inputs the bit data that corresponds to the previously mentioned matrix |*H*_{*ba*}|'s line that was input as the first Galois field transformation parameters, from the first input terminal,
-which inputs the bit data that corresponds to the input encoding target data mentioned above, from the second input terminal,
   and this Reed Solomon encoding equipment has the following systems:
-The multiple logical conjunction arithmetic system of the number that corresponds to the bit data mentioned before, which performs the arithmetic for the logical conjunction between the bit data that was input from the first input terminal mentioned previously and the bit data that was input from the second input terminal mentioned above.
-And the exclusive logical disjunction arithmetic system that performs the arithmetic for the exclusive logical disjunction of the arithmetic results of the multiple logical conjunction arithmetic process mentioned above.

### [Case 17 of the application]

The second Galois field transformation device mentioned above is the Reed Solomon decoding equipment that is described in Case 14 of the application, which forms m bit of output data D_{b-out} by performing the arithmetic process according to Equation (12) shown below, in the case that the reverse matrix of the previously described matrix |*H*_{*ba*}| is set as |*H*_{*ab*}|.

### [Equation 12]

${\text{D}}_{\text{b_out}} \text{=|} {\text{H}}_{\text{ab}} {\text{| × D}}_{\text{a_in}}$

### [Case 18 of the application]

The parameter output device mentioned above is the Reed Solomon decoding equipment that is described in Case 17 of the application, which outputs the previously described matrix |*H*_{*ab*}| to the second Galois field transformation system mentioned before, as the second Galois field transformation parameters.

### [Case 19 of the application]

The parameter output device mentioned above outputs each line of the matrix |*H*_{*ab*}| mentioned above, in due sequence line by line, to the second Galois field transformation system, as the second Galois field transformation parameter,
and the second Galois field transformation device mentioned above is the Reed Solomon decoding equipment that is described in Case 18 of the application,
-which inputs the bit data that corresponds to the previously mentioned matrix |*H*_{*ab*}|'s line that was input as the second Galois field transformation parameters, from the first input terminal,
-which inputs the bit data that corresponds to the decoded data mentioned above, from the second input terminal,
   and this Reed Solomon encoding equipment has the following systems:
-The multiple logical conjunction arithmetic system of the number that corresponds to the bit data mentioned earlier, which performs the arithmetic for the logical conjunction between the bit data that was input from the first input terminal mentioned previously and the bit data that was input from the second input terminal mentioned above.
-And the exclusive logical disjunction arithmetic system that performs the arithmetic for the exclusive logical disjunction of the arithmetic results of the multiple logical conjunction arithmetic system mentioned above.

### [Case 20 of the application]

The Reed Solomon decoding equipment that is described in Case 12 of the application,
-which also has a multiplier coefficient memory device,
-and where the parameter data mentioned above provide the multiplier coefficient that has been memorised in the multiplier coefficient memory device mentioned above, to the previously mentioned multiplier.

### [Case 21 of the application]

The Reed Solomon encoding method:
-which transforms the encoding target data into the specified Galois field data, on the basis of the first input Galois field transformation parameters,
-which performs the encoding process to the transformed encoding target data mentioned above, by the Galois field that has finished the transformation as mentioned above,
-and which performs the reverse transformation of the previously mentioned encoded data into the above-mentioned Galois field data that is as it was before the transformation, on the basis of the second Galois field transformation parameters,
   with regard to the Reed Solomon encoding system which corresponds to the multiple RS (Reed Solomon) code that uses the distinct field formation polynomial expression, input encoding target data.

### [Case 22 of the application]

The Reed Solomon encoding method described in Case 21 of the application, which has the following characteristics:
-The multiple RS codes mentioned above are the RSa code and RSb code that use the distinct field formation polynomial expression and each encoding symbol is Galois field GFₐ(2^{m}) and GF_{b}(2^{m}) having been extended on the basis of the m-th formation polynomial expressions Gpₐ(x) and Gp_{b}(x) respectively, which are on the Galois field GF (2) and distinct to each other.
-In regard to α that is the root of Gpₐ(x) mentioned above and the primitive polynomial GFₐ(2^{m}) mentioned above, and β that is the root of Gp_{b}(x) mentioned above and the primitive polynomial GF_{b}(2^{m}) mentioned above, Equation (13) shown below is concluded.
-The RSb code mentioned above represents the symbol rectification and its code formation polynomial expression G_{cb}(x) is shown in Equation (14).
-When the encoding target data mentioned above is encoded by the previously mentioned RSb code, the encoding target data mentioned above is transformed from the previously mentioned Galois field GF_{b}(2^{m}) into the data of Galois field GFₐ(2^{m}) mentioned above.
-The encoding is performed, according to Equation (15) shown below which is the polynomial expression that transforms the code formation polynomial expression G_{cb}(x) mentioned above into the Galois field GFₐ(2^{m}) mentioned above.
-And the encoded data mentioned before is reversibly transformed from the previously mentioned Galois field GFₐ(2^{m}) into the Galois field GF_{b}(2^{m}) mentioned above.

### [Equation 13]

${\text{Gp}}_{\text{b}} {\text{(α}}^{\text{p}} \text{) = 0}$

### [Equation 14]

${\text{G}}_{\text{cd}} \text{(x) =} \text{j} \text{=0} \text{L} {\text{(x+β}}^{\text{q(b+j)}} \text{)} \text{, L=2t - 1, or 2t}$

### [Equation 15]

${\text{G}}_{\text{cba}} \text{(x) =} \text{j} \text{=0} \text{L} {\text{(x+α}}^{\text{pq(b+j)}} \text{)} \text{, L=2t - 1, or 2t}$

### [Case 23 of the application]

The first Galois field transformation of the encoding target data mentioned above is the Reed Solomon encoding method described in Case 21 of the application, which has the following characteristics:
In the case that the number m among relations between 2^{m,}s transformations expresses the transverse matrix in the form of (---)^{T},
-the data (00---0001)^{T} of m bit is transformed into the data A1 = (00---001)^{T} of m bit,
-the data (00---0010)^{T} of m bit is transformed into the data A1 = (A1, m-1, A1, m-2, ---A1, 0)^{T} of m bit,
-the data (00-0100)^{T} of m bit is transformed into the data A2 = (A2, m-1, A2, m-2, --- A2, 0)^{T} of m bit,
-the data (01---0000)^{T} of m bit is transformed into the data A m-2 = (A m-2, m-1, A m-2, m-2, --- A m-2, 0)^{T} of m bit,
-the input (10-0000)^{T} of m bit is transformed into the data A m-1 = (A m-1, m-1, A m-1, m-2, --- A m-1, 0)T of m bit,
-and when the m×m matrix |*H*_{*ba*}| is regulated with Equation (16) as shown below,
   in regard to the data D_{b-in} of m bit which was mentioned above, the arithmetic process is performed according to Equation (17) shown below, and forms the data Dₐ₋ₒᵤₜ of m bit.

### [Equation 16]

$\text{|} {\text{H}}_{\text{ba}} \text{| = (A m-1 A m-2 --- A2 A1 A0)}$

### [Equation 17]

${\text{D}}_{\text{a_out}} \text{= |} {\text{H}}_{\text{ba}} {\text{| × D}}_{\text{b_in}}$

### [Case 24 of the application]

The Reed Solomon encoding method described in Case 23 of the application, which has the following characteristics:
-It uses each tine of the matrix |*H*_{*ba*}| mentioned above, in due sequence line by line, as the first Galois field transformation parameters mentioned above.
-The logical conjunction arithmetic is performed respectively between the bit data that corresponds to the previously mentioned matrix |*H*_{*ba*}|'s line and the bit data that corresponds to the previously mentioned encoding target data, which is used as the first Galois field transformation parameters.
-The transformation of the encoding target data mentioned above is performed by the arithmetic for the exclusive logical disjunction arithmetic result of the related logical conjunction.

### [Case 25 of the application]

The reverse transformation of the Galois field mentioned above is the Reed Solomon encoding method that is described in Case 23 of the application, where m bit of data D_{b-out} is formed by performing the arithmetic process according to Equation (18) shown below, in the case that the reverse matrix of the previously described matrix |*H*_{*ba*}| is set as |*H*_{*ab*}|.

### [Equation 18]

${\text{D}}_{\text{b_out}} \text{= |} {\text{H}}_{\text{ab}} {\text{| × D}}_{\text{a_in}}$

### [Case 26 of the application]

The Reed Solomon encoding method described in Case 25 of the application, which has the following characteristics:
-It uses each line of the matrix |*H*_{*ab*}| mentioned above, in due sequence line by line, as the second Galois field transformation parameters mentioned above.
-The logical conjunction arithmetic is performed respectively between the bit data that corresponds to the previously mentioned matrix |*H*_{*ab*}|'s line and the bit data that corresponds to the previously mentioned encoding target data, which is used as the second Galois field transformation parameters.
-The transformation of the encoding target data mentioned above is performed by the arithmetic for the exclusive logical disjunction arithmetic result of the related logical conjunction.

### [Case 27 of the application]

The Reed Solomon decoding equipment:
-which transforms decoding target data into the specified Galois field data, on the basis of the first Galois field transformation parameters,
-which performs the decoding process to the transformed decoding target data mentioned above, by the Galois field that has finished the transformation as mentioned above,
-and which performs the reverse transformation of the previously mentioned decoded data into the above-mentioned Galois field data which was before the transformation, on the basis of the second Galois field transformation parameters,
   with regard to the Reed Solomon decoding equipment which corresponds to the multiple RS code that uses the distinct field formation polynomial expression, input encoding target data.

### [Case 28 of the application]

The Reed Solomon decoding method described in Case 27 of the application, which has the following characteristics:
-The multiple RS codes mentioned above are the RSa code and RSb code that use the distinct field formation polynomial expression and each encoding symbol is Galois field GFₐ(2^{m}) and GF_{b}(2^{m}) that have been extended on the basis of m-th formation polynomial expression Gpₐ(x) and Gp_{b}(x) respectively, which are on the Galois field GF (2) and distinct from each other.
-In regard to α that is the root of Gpₐ(x) mentioned above and the primitive polynomial GFₐ(2^{m}) mentioned above, and β that is the root of Gp_{b}(x) mentioned above and the primitive polynomial GF_{b}(2^{m}) mentioned above, Equation (19) shown below is concluded.
-The RSb code mentioned above represents the symbol rectification and its code formation polynomial expression G_{cb}(x) is shown in Equation (20).
   When the input decoding target data mentioned above is decoded,
-the input decoding target data mentioned above is transformed from Galois field GF_{b}(2^{m}) mentioned above into the data of Galois field GFₐ(2^{m}) mentioned above,
-and the data which the previously mentioned Galois field has transformed, is decoded, according to Equation (21) shown below which is the polynomial expression that transforms the code formation polynomial expression G_{cb}(x) mentioned above into the Galois field GFₐ(2^{m}) mentioned above.
-And the reverse transformation is performed for the decoded data mentioned earlier, from the previously mentioned Galois field GFₐ(2^{m}) into the Galois field GF_{b}(2^{m}) mentioned above.

### [Equation 19]

${\text{Gp}}_{\text{b}} {\text{(α}}^{\text{p}} \text{) =0}$

### [Equation 20]

${\text{G}}_{\text{cb}} \text{(x) =} \text{j} \text{=0} \text{L} {\text{(x+β}}^{\text{q(b+j)}} \text{)} \text{, L=2t - 1, or 2t}$

### [Equation 21]

${\text{G}}_{\text{cba}} \text{(x) =} \text{j} \text{=0} \text{L} {\text{(x+α}}^{\text{pq(b+j)}} \text{)} \text{, L=2t - 1, or 2t}$

### [Case 29 of the application]

The Reed Solomon decoding method described in Case 28 of the application, which has the following characteristics:
At the time when the Galois field of the decoding target data mentioned above is transformed,
in the case that the number of m among relations between 2^{m}'s transformation expresses the transverse matrix in the form of (---)^{T},
-the data (00---0001)^{T} of m bit is transformed into the data A1 = (00---001)^{T} of m bit,
-the data (00---0010)^{T} of m bit is transformed into the data A1 = (A1, m-1, A1, m-2 , --- A1, 0)^{T} of m bit,
-the data (00---0100)^{T} of m bit is transformed into the data A2 = (A2, m-1, A2, m-2, --- A2, 0)^{T} of m bit, -the data (01--0000)^{T} of m bit is transformed into the data A m-2 = (A m-2, m-1, A m-2, m-2, --- A m-2, 0)^{T} of m bit,
-the data (10---0000)^{T} of m bit is transformed into the data A m-1 = (A m-1, m-1, A m-1, m-2, --- A m-1, 0)^{T} of m bit,
-and when the m×m matrix |*H*_{*ba*}| is regulated with the Equation (22) as shown below,
   in regard to the data D_{b-in} of m bit which was mentioned above, the arithmetic process is performed according to the Equation (23) shown below, and forms the data Dₐ₋ₒᵤₜ of m bit.

### [Equation 22]

$\text{|} {\text{H}}_{\text{ba}} \text{|= (A m-1 A m-2 --- A2 A1 A0)}$

### [Equation 23]

${\text{D}}_{\text{a_out}} \text{= |} {\text{H}}_{\text{ba}} {\text{| × D}}_{\text{b_in}}$

### [Case 30 of the application]

The Reed Solomon decoding system described in Case 29 of the application, which has the following characteristics:
-It uses each line of the matrix |*H*_{*ba*}| mentioned above, in due sequence tine by line, as the first Galois field transformation parameters mentioned above.
-The logical conjunction arithmetic is performed respectively between the bit data that corresponds to the previously mentioned matrix |*H*_{*ba*}|'s line and the bit data that corresponds to the previously mentioned decoding target data, which is used as the first Galois field transformation parameters.
-The transformation of the decoding target data mentioned above is performed by the arithmetic for the exclusive logical disjunction arithmetic result of the related logical conjunction.

### [Case 31 of the application]

The reverse transformation of the Galois field mentioned above is the Reed Solomon decoding method that is described in Case 29 of the application, where m bit of data D_{b-out} is formed by performing the arithmetic process according to Equation (24) shown below, in the case that the reverse matrix of the previously described matrix |*H*_{*ba*}| is set as |*H*_{*ab*}|.

### [Equation 24]

${\text{D}}_{\text{b_out}} \text{= |} {\text{H}}_{\text{ab}} {\text{| × D}}_{\text{a_in}}$

### [Case 32 of the application]

The Reed Solomon decoding method described in Case 31 of the application, which has the following characteristics:
-It uses each line of the matrix |*H*_{*ab*}| mentioned above, in due sequence line by line, as the second Galois field transformation parameters mentioned above.
-The logical conjunction arithmetic is performed respectively between the bit data that corresponds to the previously mentioned matrix |*H*_{*ab*}|'s line and the bit data that corresponds to the previously mentioned decoding target data, which is used as the second Galois field transformation parameters.
-The transformation of the decoding target data mentioned above is performed by the arithmetic for the exclusive logical disjunction arithmetic result of the concerned logical conjunction.

### [Detailed explanation of embodiments in accordance with the invention]

### [The technological field of invention]

This invention is related to the Reed Solomon encoding and decoding equipment and its technology, which is used as error correcting codes of the media and digital transmission.

### [The traditional technology in the past and the issues which embodiments of this invention is designed to solve]

The Reed Solomon codes system (This will be abbreviated to 'RS codes' for the rest of the document.) is used mainly for the media and digital transmission and also for codes, because of its satisfactory encoding efficiency and its suitability for eradicating errors. Also, together with the progress in IC technology, such as the encoding / decoding IC which corresponds to the codes with a relatively high correcting capability of more than 8 bites correction, being realised with one chip, its range of adaptability has become widespread.

The RS codes have the characteristic that the degree of freedom is very large with regard to the composition method of the encoding. For example, even with regard to the Galois field GF (2 ⁸) that is frequently used for the RS codes, it is fine when the cycle is 2 ⁸ - 1, in general, as the condition of its field formation polynomial expression, therefore variety exists. Furthermore, the options of the roots of the code formation polynomial expression that realise the same correcting capability are fairly extensive. That is to say, when the root of the field formation polynomial expression is α, the condition for realising the correction of t bite is to choose at least the multiplier set of consecutive α of 2 t, namely {α ^{b}, α ^{b+1}, α ^{b+2}, ---, α ^{b+2t-1}}, as the root of the code formation polynomial expression. That is, as it is possible to select any integer number, as the value of b, therefore it is the same t bite correction, and so a considerable number of RS codes exist, which are different to each other.

From the point of view of system development, this kind of degree of freedom is desirable, but from the viewpoint of standardisation, it becomes the opposite. Due to demands such as correcting capability, etc., the element number 2 ⁸'s Galois field GF (2 ⁸) is typical, but other parameters vary. The length of the codes or their correcting capability vary according to the specifications of each demand and it is logical, but the one that has the biggest influence among insignificant variation, is the difference in the field formation polynomial expression. For example, when the RS encoding / decoding equipment that corresponds to two systems is set up, if the field formation polynomial expression is different, the multiplier of each Galois field is also different, thus it can not be made as unified. Especially when it corresponds the one that has a large correcting capability, the proportion, which the multiplier of the Galois field mentioned above occupies, is large. And in the conventional system, there is the problem that the equipment becomes highly priced, as it is equipped with each Galois field multiplier, which corresponds to two systems.

In fact, even in the same field of digital transmission, there is a difference between the field formation polynomial expression that is applied to satellite communications, and the field formation polynomial expression that is applied to satellite broadcasting. The main reason for this is because standardisation was difficult, due to the difference in jurisdiction between the field of communications and
the field of broadcasting. Also, at the time of standardisation, the necessity for establishing a common field formation polynomial expression was not great. In recent years, in spite of the necessity becoming evident during the examination of integration between communications and broadcasting, it has been extremely difficult to make alterations with regard to areas where standardisation has already been completed. Needless to say, with regard to the application of the RS codes to the media, a lot of their development is mainly lead by the manufacturers, and there are different media which have been developed by different manufacturers, therefore it is extremely rare for the same field formation polynomial expression to be applied.

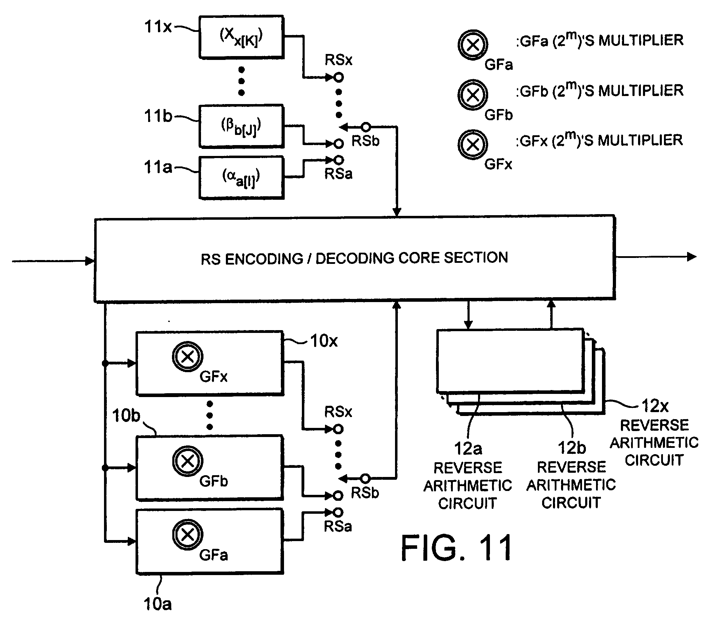

Diagram 11 is the conception diagram of the conventional RS encoding / decoding equipment which corresponds to more than two RS codes, that is to say, RSa code, RSb code, ---, RSx code. It is equipped with each multiplier 10a ∼ 10x of the Galois field GFₐ(2^{m}), GF_{b}(2^{m}), ---, GFₓ(2^{m}), which correspond to each field formation polynomial expression, and is also equipped with the multiplier coefficient memory section of 11a ∼ 11x, which memorises the Galois field's multiplier coefficient set of {α a [I]}, {β b [J]}, ---, {χ x [K]}, which corresponds to each code formation polynomial expression. The conventional RS encoding / decoding equipment is equipped with the reverse original arithmetic circuit 12a ∼ 12x, corresponding to each code, for the further division.

In order to make the explanations simple for the rest of this document, the conventional RS encoding / decoding equipment 1 which corresponds to two RS codes, that is to say RSa code and RSb code, is referred to. Incidentally, with regard to both RSa code and RSb code, the correcting capability is to be the bite correction.

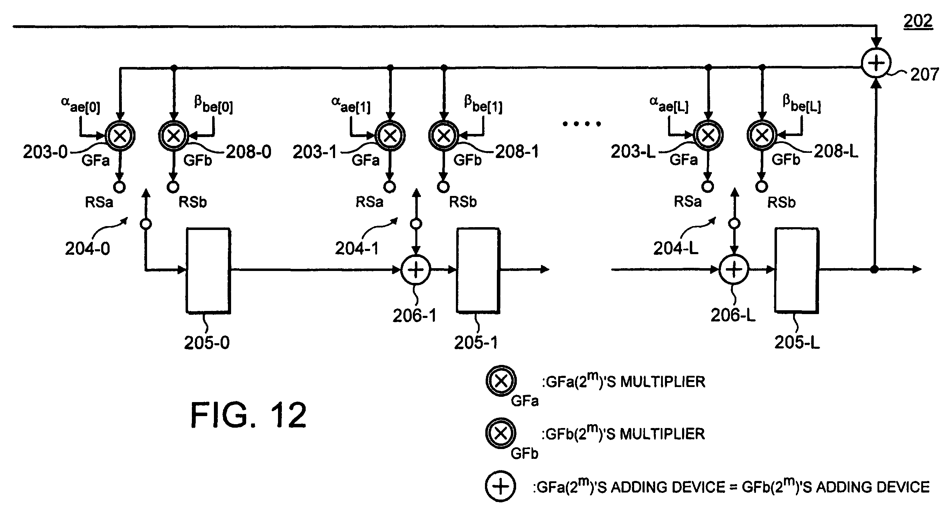

Diagram 12 is the surplus arithmetic circuit 202 of the polynomial expression, which represents the conventional RS encoding / decoding equipment 1. In the surplus arithmetic circuit 202, the Galois field's multiplier coefficient set of {αₐₛ [i]}, $\text{i = 0 ∼ L}$, belongs to the previously mentioned Galois field's multiplier coefficient set of {αₐ [I]}, and the Galois field's multiplier coefficient set of {β_{ba} [j]}, $\text{j = 0 ∼ L}$, belongs to the previously mentioned Galois field's multiplier coefficient set of {β_{b}[J]}. L is 2 t - 1 or 2 t. (The same applies for the rest of the document.)

As is shown in Diagram 12, the surplus arithmetic circuit 202 of the polynomial expression has a multiplier 203-0∼203-L, a multiplier 208-0∼208-L, a switch 204-0∼204-L, a register 205-0∼205-L, an adding device 206-1∼206-L and an adding device 207.
With regard to the switch 204-0∼204-L, in the case of RSa encoding, a multiplier 203-0∼203-L is selected, and in the case of RSb encoding, a multiplier 208-0∼208-L is selected.

The RS decoding machine is generally composed of the syndrome arithmetic circuit, error location polynomial expression and valuation polynomial expression arithmetic circuits, error locator (error location detection) circuit, and evaluation value detection circuit and correcting execution circuit. Among the above, with regard to the error location polynomial expression and valuation polynomial expression arithmetic circuits, Euclid's mutual division method or the method of Berlekamp - mash (erasure) are known.

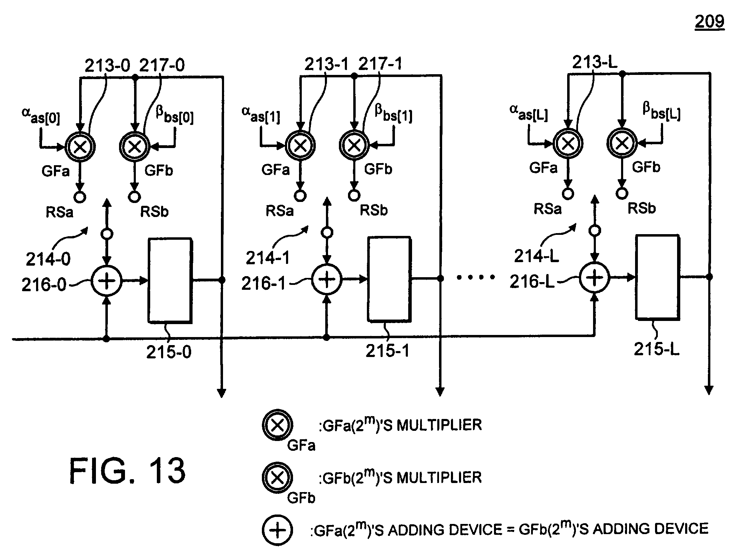

Diagram 13 is an example of the conventional composition of the syndrome arithmetic circuit 209, which corresponds to the two RS codes mentioned above. In this case, the Galois field's multiplier coefficient set of {αₐₛ [i]}, $\text{i = 0 ∼ L}$ belongs to the previously mentioned {αₐ [I]}, and the Galois field's multiplier coefficient set of {β_{bs} [j]}, $\text{j = 0∼L}$, belongs to the previously mentioned {β_{b}[J]}.

As is shown in Diagram 13, the syndrome arithmetic circuit 209 has a multiplier 213-0∼213-L, a switch 214-0-214-L, a register 215-0∼215-L, an adding device 216-0∼216-L and a multiplier 217-0∼217-L.
With regard to the switch 214-0∼214-L, in the case of RSa encoding, a multiplier 213-0∼213-L is selected, and in the case of RSb encoding, a multiplier 217-0∼217-L is selected.

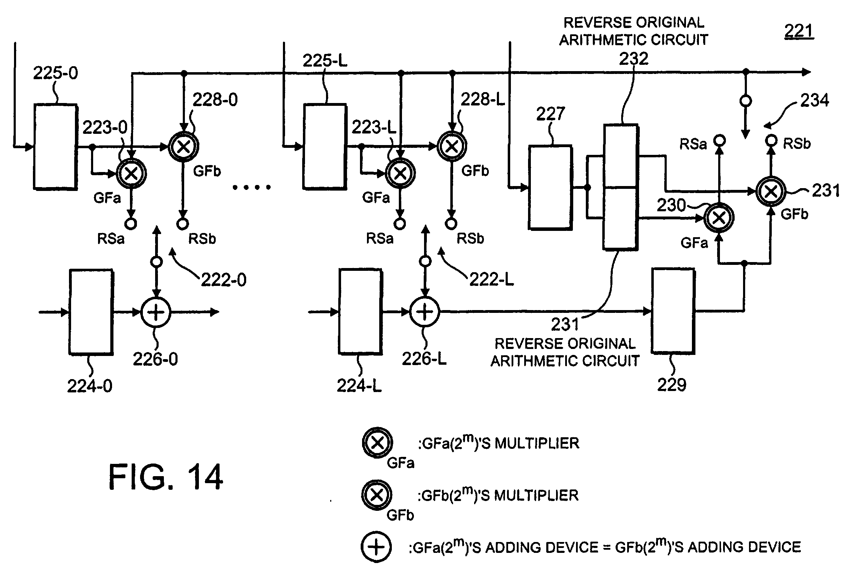

Diagram 14 is an example of the conventional composition of the polynomial expression division circuit 221, which is one of the major composition elements of the error location polynomial expression and valuation polynomial expression arithmetic circuits, and which corresponds to the two RS codes mentioned above.
As is shown in Diagram 14, the division circuit 221 of polynomial expression has a switch 222-0∼222-L, a multiplier 223-0∼223-L, a multiplier 228-0∼228-L, a register 225-0∼225-L, a register 224-0∼224-L, an adding device 226-0∼226-L, registers 227, 229, reverse original circuits 231, 232, multiplier 230, 231 and a switch 234.
With regard to the switch 222-0∼222-L, in the case of RSa encoding, a multiplier 223-0∼223-L is selected, and in the case of RSb encoding, a multiplier 228-0∼228-L is selected.

Also with regard to the switch 234, in the case of RSa encoding, a multiplier 230 is selected, and in the case of RSb encoding, a multiplier 231 is selected.

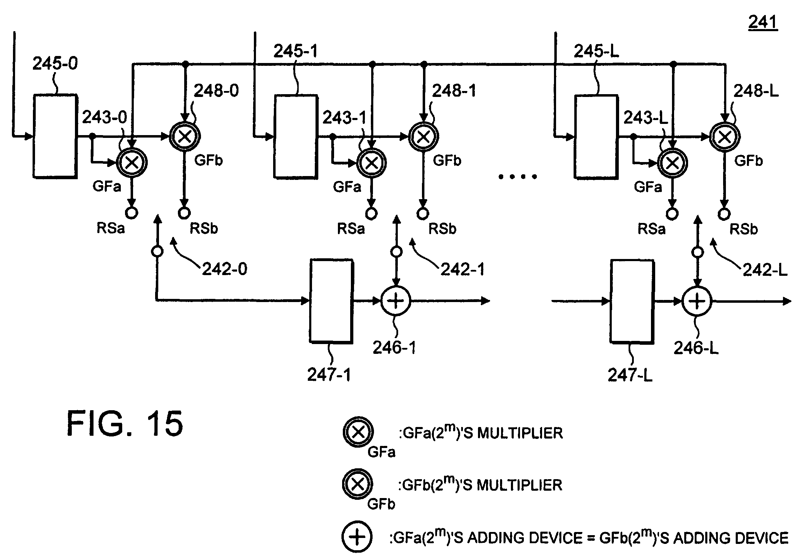

Diagram 15 is an example of the conventional composition of the polynomial expression multiplier circuit 241, which is one of the major composition elements of the error location polynomial expression and valuation polynomial expression arithmetic circuits, and which corresponds to the two RS codes mentioned above.
As is shown in Diagram 15, the multiplier circuit 241 of polynomial expression has a multiplier 243-0∼243-L, a multiplier 248-0∼248-L, a switch 242-0∼242-L, a register 245-0∼245-L, an adding device 246-1∼246-L and a register 247-0∼247-L.
With regard to the switch 242-0∼242-L, in the case of RSa encoding, a multiplier 243-0∼243-L is selected, and in the case of RSb encoding, a multiplier 248-0∼248-L is selected.

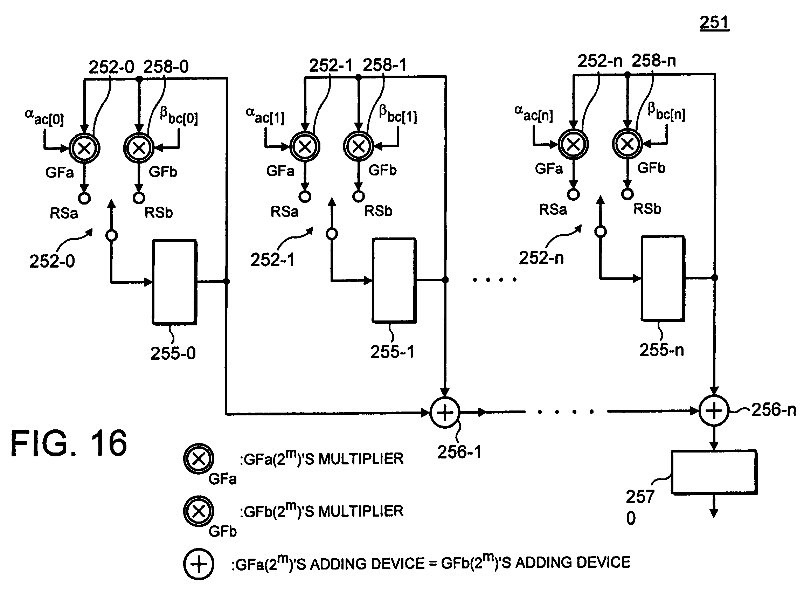

Diagram 16 is an example of the conventional composition of the error location detection circuit 251, which corresponds to the two RS codes mentioned above. As is shown in Diagram 16, the error location detection circuit 251has a multiplier 252-0∼252-n, a multiplier 258-0∼258-n, a switch 252-0∼252-n, a register 255-0∼255-n, an adding device 256-1∼256-n 0 and a detection circuit 257.
With regard to the switch 252-0∼252-n, in the case of RSa encoding, a multiplier 252-0∼252-n is selected, and in the case of RSb encoding, a multiplier 258-0∼258-n is selected.
In this case, the Galois field's multiplier coefficient set of {α_{ac} [i]}, $\text{i = 0 ∼ n = t}$ belongs to the previously mentioned {αₐ [I]), and the Galois field's multiplier coefficient set of {β_{bc} [j]}, $\text{j = 0 ∼ n = t}$, belongs to the previously mentioned {β_{b}[J]}. When the loss correcting is performed, $\text{i = 0 ∼ n = 2 t}$, and $\text{j = 0 ∼ n = 2 t}$.

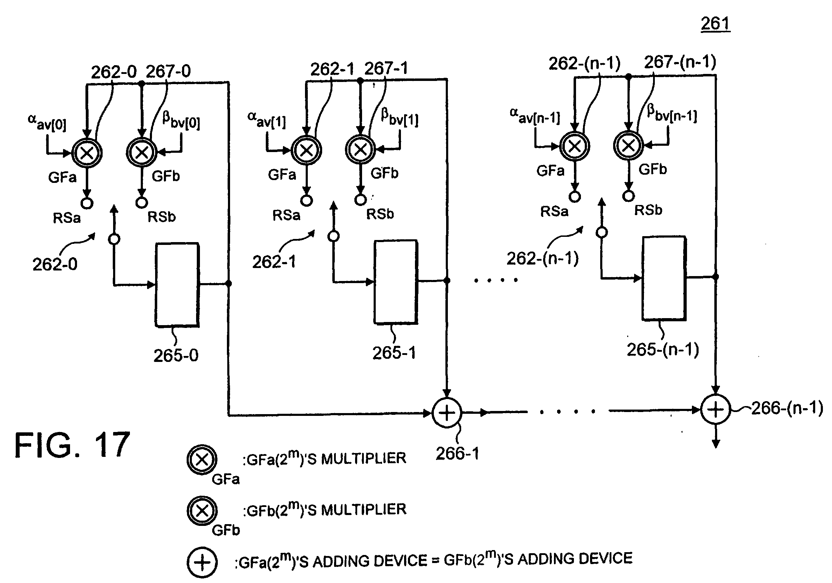

Diagram 17 is an example of the conventional composition of the evaluation value detection circuit 261, which corresponds to the two RS codes mentioned above.
As is shown in Diagram 17, the evaluation value detection circuit 261has a multiplier 262-0∼262-(n-1), a multiplier 267-0∼267-(n-1), a switch 262-0∼262-(n-1), a register 265-0∼265-(n-1), an adding device 266-1∼266-(n-1).
With regard to the switch 262-0∼262-(n-1), in the case of RSa encoding, a multiplier 262-0∼262-(n-1) is selected, and in the case of RSb encoding, a multiplier 267-0∼267-(n-1) is selected.

In this case, the Galois field's multiplier coefficient set of {αₐᵥ [i]}, $\text{i = 0 ∼ n -1}$ belongs to the previously mentioned {αₐ [I]}, and the Galois field's multiplier coefficient set of {β_{bv} [j]}, $\text{j = 0 ∼ n -1}$, belongs to the previously mentioned {β_{b}[J]}.

As shown above, in the past, in order to set up RS encoding / decoding equipment that corresponds to more than two RS codes, it is necessary to use It after being equipped with the Galois field multiplier and the reverse original arithmetic circuit, which correspond to each field formation polynomial expression, and by switching them.

Also, in the previously mentioned composition, in the case of altering the Galois field of the encoding target data and decoding target data, it is necessary to change the hardware composition. And there is the problem that it is impossible to perform the encoding and decoding of the various Galois field data smoothly.

An aim of embodiments of this invention is to provide the Reed Solomon encoding equipment and its operating system, attempting to reduce the size and price of the equipment, taking into account the conventional technology mentioned above.
Embodiments of this invention also aims at providing the Reed Solomon encoding equipment with a system that can smoothly perform the encoding of the various Galois field data.
Also, the aim of embodiments of this invention is to provide the Reed Solomon decoding method and its equipment, attempting to reduce the equipment size and its price.
At the same time, embodiments of this invention aims at providing the Reed Solomon decoding equipment with a system that can smoothly perform the encoding of the various Galois field data.

### [The means of solving the points at issue]

In order to solve the problems of the technology of the past and to achieve the aims mentioned above, the Reed Solomon encoding equipment of embodiments of this invention, which corresponds to the multiple RS (Reed Solomon) codes that use the distinct field formation polynomial expression, has:
-the first Galois field transformation method that transforms input encoding target data into the specified Galois field data, on the basis of the first input Galois field transformation parameters,
-the encoding method that performs the encoding process on the transformed encoding target data mentioned above, by the Galois field that has finished the transformation as is mentioned above,
-the second Galois field transformation method that performs the reverse transformation from the previously mentioned encoded data into the above-mentioned Galois field data as it was before the transformation, on the basis of the second input Galois field transformation parameters,
-and the parameter output method which outputs the first Galois field transformation parameter mentioned above and the second Galois field transformation parameters.

In the Reed Solomon encoding equipment of embodiments of this invention, the first Galois field transformation device and the second Galois field transformation device are installed, therefore it is possible to perform the encoding process even to any one of the multiple RS codes, by using the fixed Galois field in regard to the encoding device. As the result of that, it becomes unnecessary to install the multiplier and the reverse original arithmetic functional unit (processor) separately in the encoding device, which corresponds to all of the multiple RS codes, therefore it is possible to reduce the scale of the circuit greatly.
Also, the first Galois field transformation device and the second Galois field transformation device can be altered by performing each Galois field transformation, on the basis of the first Galois field transformation parameters and the second Galois field transformation parameters, which have been output from each parameter output device. Therefore it is possible to alter the contents of the Galois fields in various ways and smoothly.

Also, in the Reed Solomon encoding equipment of embodiments of this invention, preferably, the encoding device mentioned above has a multiplier that corresponds to the Galois field after the previously mentioned transformation.

And in the Reed Solomon encoding equipment of embodiments of this invention, preferably,
-The multiple RS codes mentioned above are the RSa code and RSb code that used the distinct field formation polynomial expression and each encoding symbol is Galois field GFₐ(2^{m}) and GF_{b}(2^{m}) that have been extended on the basis of m-th formation polynomial expression Gpₐ(x) and Gp_{b}(x) respectively, which are on the Galois field GF (2) and distinct from each other.
-In regard to α that is the root of Gpₐ(x) mentioned above and the primitive polynomial GFₐ(2^{m}) mentioned above, and β that is the root of Gp_{b}(x) mentioned above and the primitive polynomial GF_{b}(2^{m}) mentioned above, Equation (25) shown below is concluded.
-The RSb code mentioned above is the symbol rectification and its code formation polynomial expression G_{cb}(x) is shown in Equation (26).
-When the input encoding target data mentioned above is encoded by the previously mentioned RSb code, the first Galois field transformation device mentioned above transforms the input encoding target data mentioned above into the data of Galois field GFₐ(2^{m}) mentioned above from Galois field GF_{b}(2^{m}) mentioned above.
-And the encoding device mentioned above performs the encoding, according to Equation (27) shown below which is the polynomial expression that transforms the code formation polynomial expression G_{cb}(x) mentioned above into the Galois field GFₐ(2^{m}) mentioned above.
-The second Galois field transformation device mentioned above performs the reverse transformation of the encoded data mentioned before from the previously mentioned Galois field GFₐ(2^{m}) into the Galois field GF_{b}(2^{m}) mentioned above.

### [Equation 25]

${\text{Gp}}_{\text{b}} {\text{(α}}^{\text{p}} \text{) = 0}$

### [Equation 26]

${\text{G}}_{\text{cb}} \text{(x) =} \text{j} \text{=0} \text{L} {\text{(x+β}}^{\text{q(b+j)}} \text{)} \text{, L=2t - 1, or 2t}$

### [Equation 27]

${\text{G}}_{\text{cba}} \text{(x) =} \text{L} \text{j} \text{=0} {\text{(x+α}}^{\text{pq(b+j)}} \text{)} \text{, L=2t - 1, or 2t}$

Also, in the Reed Solomon encoding equipment of embodiments of this invention, preferably:
In the case that the number of m among relations between 2^{m}'s input and output expresses the transverse matrix in the way of (---)^{T},
-in regard to the input (00---0001)^{T} of m bit, the output A₁ = (00---001)^{T} of m bit is produced,
-in regard to the input (00---0010)^{T} of m bit, the output A₁ = (A₁, ₘ₋₁, A₁, ₘ₋₂, ---A₁, 0)^{T} of m bit is produced,
-in regard to the input (00---0100)^{T} of m bit, the output A₂ = (A₂, ₘ₋₁, A₂, ₘ₋₂, ---A₂, 0)^{T} of m bit is produced,
-in regard to the input (01---0000)^{T} of m bit, the output Aₘ₋₂ = (Aₘ₋₂, ₘ₋₁, Aₘ₋₂, ₘ₋₂, --- Aₘ₋₂, 0)^{T} of m bit is produced,
-in regard to the input (10---0000)^{T} of m bit, the output Aₘ₋₁ = (Aₘ₋₁, ₘ₋₁, Aₘ₋₁, ₘ₋₂, --- Aₘ₋₁, 0)^{T} of m bit is produced,
-and when the m×m matrix |*H*_{*ba*}| is regulated with the Equation (28) as shown below,
   in regard to the input data D_{b-in} of m bit which was mentioned above, the arithmetic process is produced according to the Equation (29) shown below, and forms the output data Dₐ₋ₒᵤₜ of m bit.

### [Equation 28]

$\text{|} {\text{H}}_{\text{ba}} {\text{| = (A}}_{\text{m-1}} {\text{A}}_{\text{m-2}} {\text{--- A}}_{\text{2}} {\text{A}}_{\text{1}} {\text{A}}_{\text{0}} \text{)}$

### [Equation 29]

${\text{D}}_{\text{a_out}} \text{= |} {\text{H}}_{\text{ba}} {\text{| × D}}_{\text{b_in}}$

Also, in the Reed Solomon encoding equipment of embodiments of this invention, preferably, the parameter output device mentioned above outputs the matrix [Hba] mentioned above, as the first Galois field transformation parameter mentioned above.

Also, in the Reed Solomon encoding equipment of embodiments of this invention, preferably:
The parameters output device mentioned above outputs each tine of the matrix [Hba] mentioned above, in due sequence tine by line, to the first Galois field transformation device, as the first Galois field transformation parameters,
-which inputs the bit data that corresponds to the previously mentioned matrix [Hba]'s line that was input as the first Galois field transformation parameters, from the first input terminal,
-which inputs the bit data that corresponds to the input encoding target data mentioned above, from the second input terminal, and this Reed Solomon encoding equipment has the following system:
-The multiple logical conjunction arithmetic device of the number that corresponds to the bit data mentioned earlier, which performs the arithmetic for the logical conjunction between the bit data that was input from the first input terminal mentioned previously and the bit data that was input from the second input terminal mentioned above.
-And the exclusive logical disjunction arithmetic device that performs the arithmetic for the exclusive logical disjunction of the arithmetic result of the multiple logical conjunction arithmetic device mentioned above.

Also, in the Reed Solomon encoding equipment of embodiments of this invention, preferably, the second Galois field transformation device mentioned above forms m bit of output data D_{b-out} by performing the arithmetic process according to Equation (30) shown below, in the case that the reverse matrix of the previously described matrix |*H*_{*ba*}| is set as |*H*_{*ab*}|.

### [Equation 30]

${\text{D}}_{\text{b_out}} \text{= |} {\text{H}}_{\text{ab}} {\text{|× D}}_{\text{a_in}}$

Also, in the Reed Solomon encoding equipment of embodiments of this invention, preferably, the parameter output device mentioned above outputs the previously described matrix |*H*_{*ab*}| to the second Galois field transformation device mentioned before, as the second Galois field transformation parameters.
Also, in the Reed Solomon encoding equipment of embodiments of this invention, preferably:
The parameter output device mentioned above outputs each line of the matrix |*H*_{*ab*}| mentioned above, in due sequence line by line, to the second Galois field transformation device, as the second Galois field transformation parameter, and the second Galois field transformation device mentioned above is the Reed Solomon encoding equipment:
-which inputs the bit data that corresponds to the previously mentioned matrix [Hab]'s line that was input as the second Galois field transformation parameters, from the first input terminal,
-which inputs the bit data that corresponds to the encoded data mentioned above, from the second input terminal,
   and this Reed Solomon encoding equipment has the following device:
-The multiple logical conjunction arithmetic device of the number that corresponds to the bit data mentioned earlier, which performs the arithmetic for the logical conjunction between the bit data that was input from the first input terminal mentioned previously and the bit data that was input from the second input terminal mentioned above.
-And the exclusive logical disjunction arithmetic device that performs the arithmetic for the exclusive logical disjunction of the arithmetic result of the multiple logical conjunction arithmetic device mentioned above.

Preferably, the Reed Solomon encoding equipment of embodiments of this invention, also has the multiplier coefficient memory device, and the parameter measures mentioned above supplies the multiplier coefficient that has been memorised in the multiplier coefficient memory device mentioned above, to the previously mentioned multiplier.

Also, the Reed Solomon decoding equipment of embodiments of this invention corresponds to the multiple RS code that uses the different field formation polynomial expression, input encoding target data.
And it has:
-the first Galois field transformation device that transforms input decoding target data into the specified Galois field data, on the basis of the first input Galois field transformation parameters,
-the decoding device that performs the decoding process to the transformed decoding target data mentioned above, by the Galois field that has finished the transformation as is mentioned above,
-the second Galois field transformation device that performs the reverse transformation of the previously mentioned decoded data into the above-mentioned Galois field data as it was before the transformation, on the basis of the second input Galois field transformation parameters,
-and the parameter output device which outputs the first Galois field transformation parameter mentioned above and the second Galois field transformation parameters,
   with regard to the Reed Solomon decoding equipment which corresponds to the multiple RS code that uses the different field formation polynomial expression, input encoding target data.

In the Reed Solomon decoding equipment of embodiments of this invention, the first Galois field transformation device and the second Galois field transformation device are installed, therefore it is possible to perform the decoding process even to any one of the multiple RS codes, by using the fixed Galois field in regard to the decoding device. As a result of that, it becomes unnecessary to install the multiplier and the reverse original arithmetic functional unit (processor) separately in the decoding device, which corresponds to all of the multiple RS codes, therefore it is possible to reduce the scale of the circuit greatly.
Also, the first Galois field transformation device and the second Galois field transformation device can be altered by performing each Galois field transformation, on the basis of the first Galois field transformation parameters and the second Galois field transformation parameters, which have been output from each parameter output device. Therefore it is possible to alter the contents of the Galois fields in various ways and smoothly.

Also, in the Reed Solomon decoding equipment of embodiments of this invention, preferably, the decoding device mentioned above has a multiplier that corresponds to the Galois field after the previously mentioned transformation.

And in the Reed Solomon decoding equipment of embodiments of this invention, preferably,
-The multiple RS codes mentioned above are the RSₐ code and RS_{b} code that use the different field formation polynomial expression and each decoding symbol is Galois field GFₐ(2^{m}) and GF_{b}(2^{m}) that have been extended on the basis of m-th formation polynomial expression Gpₐ (x) and Gp_{b} (x) respectively, which are on the Galois field GF (2) and distinct from each other.
-In regard to α that is the root of Gpₐ (x) mentioned above and the primitive polynomial GFₐ (2^{m}) mentioned above, and β that is the root of Gp_{b} (x) mentioned above and the primitive polynomial GF_{b} (2^{m}) mentioned above, Equation (31) shown below is concluded.
-The RSb code mentioned above is the symbol rectification and its code formation polynomial expression G_{cb}(x) is shown in Equation (32).
-When the input decoding target data mentioned above is decoded, the first Galois field transformation device mentioned above transforms the input decoding target data mentioned above into the data of Galois field GFₐ(2^{m}) mentioned above from Galois field GF_{b}(2^{m}) mentioned above.
-And the decoding device mentioned above performs the decoding, according to Equation (33) shown below which is the polynomial expression that transforms the code formation polynomial expression G_{cb}(x) mentioned above into the Galois field GFₐ(2^{m}) mentioned above.
-The second Galois field transformation device mentioned above performs the transformation of the decoded data mentioned earlier from the previously mentioned Galois field GFₐ(2^{m}) into the Galois field GF_{b}(2^{m}) mentioned above.

### [Equation 31]

${\text{Gp}}_{\text{b}} {\text{(α}}_{\text{p}} \text{)=0}$

### [Equation 32]

${\text{G}}_{\text{cb}} \text{(x) =} \text{j} \text{=0} \text{L} {\text{(x+β}}^{\text{q(b+j)}} \text{)} \text{, L=2t - 1, or 2t}$

### [Equation 33]

$\text{Gcba(x) =} \text{j} \text{=0} \text{L} {\text{(x+α}}^{\text{pq(b+j)}} \text{)} \text{, L=2t- 1, or 2t}$

Also, in the Reed Solomon decoding equipment of embodiments of this invention, preferably:
In the case that the number of m among relations between 2^{m}'s input and output expresses the transverse matrix in the way of (---)^{T},
-in regard to the input (00---0001)^{T} of m bit, the output A₁ = (00---001)^{T} of m bit is produced,
-in regard to the input (00---0010)^{T} of m bit, the output A₁ = (A₁, ₘ₋₁, A₁, ₘ₋₂, ---A₁, 0)^{T} of m bit is produced,
-in regard to the input (00-0100)^{T} of m bit, the output A₂ = (A₂, ₘ₋₁, A₂, ₘ₋₂, ---A₂, 0)^{T} of m bit is produced,
-in regard to the input (01---0000)^{T} of m bit, the output Aₘ₋₂ = (Aₘ₋₂, ₘ₋₁, Aₘ₋₂, ₘ₋₂, --- Aₘ₋₂, 0)^{T} of m bit is produced,
-in regard to the input (10---0000)^{T} of m bit, the output Aₘ₋₁ = (Aₘ₋₁, ₘ₋₁, Aₘ₋₁, ₘ₋₂, --- Aₘ₋₁, 0)^{T} of m bit is produced,
-and when the m×m matrix |*H*_{*ba*}| is regulated with the Equation (34) as shown below,
   in regard to the input data D_{b-in} of m bit which was mentioned above, the arithmetic process is produced according to the Equation (35) shown below, and forms the output data Dₐ₋ₒᵤₜ of m bit.

### [Equation 34]

$\text{|} {\text{H}}_{\text{ba}} {\text{| = (A}}_{\text{m-1}} {\text{A}}_{\text{m-2}} {\text{, --- A}}_{\text{2}} {\text{A}}_{\text{1}} {\text{A}}_{\text{0}} \text{)}$

### [Equation 35]

${\text{D}}_{\text{a_out}} \text{= |} {\text{H}}_{\text{ba}} {\text{| × D}}_{\text{b_in}}$

Also, in the Reed Solomon decoding equipment of embodiments of this invention, preferably, the parameter output device mentioned above outputs the matrix |*H*_{*ba*}| mentioned above, as the first Galois field transformation parameters mentioned above.

Also, in the Reed Solomon decoding equipment of embodiments of this invention, preferably:
The parameter output device mentioned above outputs each line of the matrix |*H*_{*ba*}|mentioned above, in due sequence line by line, to the first Galois field transformation device, as the first Galois field transformation parameters,
-which inputs the bit data that corresponds to the previously mentioned matrix|*H*_{*ba*}|'s line that was input as the first Galois field transformation parameters, from the first input terminal,
-which inputs the bit data that corresponds to the input encoding target data mentioned above, from the second input terminal,
   and this Reed Solomon encoding equipment has the following device:
-The multiple logical conjunction arithmetic device of the number that corresponds to the bit data mentioned earlier, which performs the arithmetic for the logical conjunction between the bit data that was input from the first input terminal mentioned previously and the bit data that was input from the second input terminal mentioned above.
-And the exclusive logical disjunction arithmetic device that performs the arithmetic for the exclusive logical disjunction of the arithmetic result of the multiple logical conjunction arithmetic device mentioned above.

Also, in the Reed Solomon decoding equipment of embodiments of this invention, preferably, the second Galois field transformation device mentioned above forms m bit of output data D_{b-out} by performing the arithmetic process according to Equation (36) shown below, in the case that the reverse matrix of the previously described matrix |*H*_{*ba*}| is set as |*H*_{*ab*}|.

### [Equation 36]

${\text{D}}_{\text{b_out}} \text{= |} {\text{H}}_{\text{ab}} {\text{| × D}}_{\text{a_in}}$

Also, in the Reed Solomon decoding equipment of embodiments of this invention, preferably, the parameter output device mentioned above outputs the previously described matrix |*H*_{*ab*}| to the second Galois field transformation device mentioned before, as the second Galois field transformation parameters.

Also, in the Reed Solomon decoding equipment of embodiments of this invention, preferably:
The parameter output device mentioned above outputs each line of the matrix |*H*_{*ab*}| mentioned above, in due sequence of every line, to the second Galois field transformation device, as the second Galois field transformation parameters,
and the second Galois field transformation device mentioned above is the Reed Solomon encoding equipment:
-which inputs the bit data that corresponds to the previously mentioned matrix |*H*_{*ab*}|'s line that was input as the second Galois field transformation parameters, from the first input terminal,
-which inputs the bit data that corresponds to the encoded data mentioned above, from the second input terminal,
   and this Reed Solomon encoding equipment has the following device:
-The multiple logical conjunction arithmetic device of the number that corresponds to the bit data mentioned before, which performs the arithmetic for the logical conjunction between the bit data that was input from the first input terminal mentioned previously and the bit data that was input from the second input terminal mentioned above.
-And the exclusive logical disjunction arithmetic device that performs the arithmetic for the exclusive logical disjunction of the arithmetic result of the multiple logical conjunction arithmetic device mentioned above.

Preferably, the Reed Solomon decoding equipment of embodiments of this invention, also has a multiplier coefficient memory device, and the parameter measures mentioned above provide the multiplier coefficient that has been memorised in the multiplier coefficient memory device mentioned above, to the previously mentioned multiplier.

### [The form of practical application of embodiments of this invention]

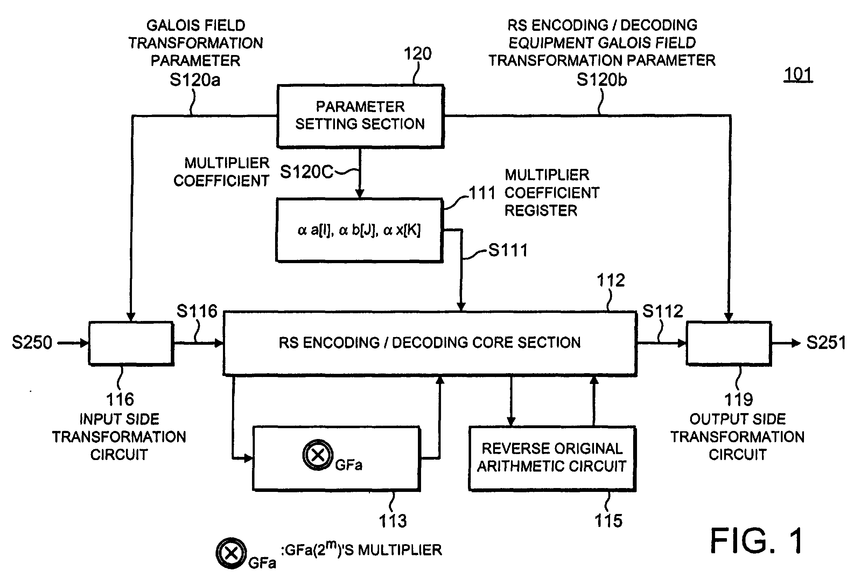

Diagram 1 is the concept diagram of the RS encoding / decoding equipment 101 representing the practical application of this invention.
The RS encoding / decoding equipment 101 corresponds to more than two RS codes, i.e, RSₐ code, RS_{b} code, --- RSx.
In Diagram 1, there are the Galois field multiplier 113 that corresponds to the GFₐ(2^{m}) field formation polynomial expression, the multiplier coefficient memory section 111 that memorises the Galois field multiplier coefficient set of {α_{a[I]}}, {α_{b[J]}}, --- {α_{x[k]}} that corresponds to each code formation polynomial expression, the RS coding / decoding core section 112, the reverse original arithmetic circuit 115, the input side transformation circuit 116, the output side transformation circuit 119 and the parameter setting section 120.

As shown in Diagram 1, the RS encoding / decoding equipment 101 is set up in such a way that the input side transformation circuit 116, and the output side transformation circuit 119, in order to transform the Galois field, are added to the input side and the output side of the RS encoding / decoding core section 112.
Also, the input side transformation circuit 116 and the output side transformation circuit 119 perform the transformation of the data, on the basis of the Galois field transformation parameters S120a and S120b.
And, the RS encoding / decoding core section 112 performs the encoding and decoding, on the basis of the multiplier S120c that is input from the parameter setting section 120.
The Galois field transformation parameters S120a, S120b and the multiplier coefficient S120c, which are output from the parameter setting section 120, can be altered, according to the type of RS encoding and RS decoding, for example, according to the user's instructions.

In order to make the explanations simple for the rest of this document, the conventional RS encoding / decoding equipment 1, which corresponds to two RS codes, that is to say RSₐ code and RS_{b} code, is illustrated here. It may be noted that, with regard to both codes, the correcting capability is the t bite correction.
In this example of the practical application, the RS encoding and decoding, in the case that q = 88 and m = 8, in regard to Equation (25) ∼ (30) which are mentioned above, are illustrated.

In this example of the practical application, the encoding / decoding systems of the codes and their installation are the main subject, therefore with regard to the RSₐ code mentioned above, the only necessary condition is simply that the degree of its field formation polynomial expression is simply the same as that of the RS_{b} code. Also in this example of the practical application, the correcting capability of the RSₐ code mentioned above, is made to be the t bite correction as with the RS_{b} code mentioned above.

### RSa code

For the RSa code mentioned above, the field formation polynomial expression of the GF(2) which makes the basic body GF_{a-B}(2⁸), where the encoding symbol is defined, is given as shown in the following Equation (37).

### [Equation 37]

${\text{Gp}}_{\text{a}} {\text{(x) = x}}^{\text{8}} {\text{+ x}}^{\text{4}} {\text{+x}}^{\text{3}} {\text{+x}}^{\text{2}} \text{+ 1}$

Furthermore, the code formation polynomial expression of the RSa code mentioned above, is defined as shown in following Equation (38).

### [Equation 38]

${\text{G}}_{\text{ca}} \text{(x) =} \text{j} \text{=0} \text{L} {\text{(x+α}}^{\text{b+j}} \text{)} \text{, L=2t - 1, or 2t}$

The coefficient of x in this case is the element of GF_{a-B}(2⁸) which is the magnified body, and is the same as GF_{a-E}(2⁸) which is the basic body. That is to say, In this example of the practical application, the Galois field GF_{a-B}(2⁸) which is the object of the transformation, is equivalent to GF_{a-E}(2⁸).

Also, the primitive element of ${\text{GF}}_{\text{a}} {\text{(2}}^{\text{8}} {\text{) = GF}}_{\text{a-B}} {\text{(2}}^{\text{8}} \text{)}$ mentioned above, which is also the root of Gpₐ(x) mentioned previously, is made to be α. This α is (00000010) ^{T} when it is expressed as the linear vector for the convenience of explanation. And the following Equation (39) is concluded from Equation (37).

### [Equation 39]

${\text{α}}^{\text{8}} {\text{=α}}^{\text{4}} {\text{+α}}^{\text{3}} {\text{+α}}^{\text{2}} \text{+1}$

When this is expressed as the linear vector, ${\text{(α}}^{\text{8}} {\text{) a = (00011101)}}^{\text{T}}$.
(x) a here indicates the linear vector expression of the element X of GFₐ(2⁸) mentioned above. Also, ${\text{(α}}^{\text{0}} {\text{) a = (1) a = (00000001)}}^{\text{T}}$.

### RS_{b} code

For the RSₐ code mentioned above, the field formation polynomial expression of the GF(2) that makes the basic body, where the encoding symbol is defined, is given as shown in the following Equation (40).

### [Equation 40]

${\text{Gp}}_{\text{b}} {\text{(x) = x}}^{\text{8}} {\text{+ x}}^{\text{5}} {\text{+ x}}^{\text{3}} {\text{+ x}}^{\text{2}} \text{+ 1}$

Furthermore, the code formation polynomial expression of the RS_{b} code mentioned above, is defined as shown in the following Equation (41).

### [Equation 41]

${\text{G}}_{\text{cb}} \text{(x)=} \text{j} \text{=0} \text{L} {\text{(x + β}}^{\text{88(b+j)}} \text{)} \text{, L=2t- 1, or 2t}$

Equation (41) is where q = 88 with regard to Equation (26) as stated above. Strictly speaking, this RS code is included in Goppa codes, and although x's coefficient of Equation (41) mentioned above can be expressed with the element of GF_{b-B}(2⁸), it is different from GF_{b-B}(2⁸) which is the basic body of the encoding magnified body GF_{b-B}(2⁸). In this example of the practical application, the previously mentioned Galois field GF_{b}(2⁸) that is the object of the transformation, is equivalent to GF_{b-B}(2⁸). And with regard to the Euclidean decoding method of the Goppa codes mentioned above, it is stated in detail in the document 'A method for solving the key equation for decoding Goppa codes, Inf. and Cont., 27, 1975, written by Sugiyama, Kasahara, Hirasawa', and with regard to its loss correction method, it is described in detail in the document 'An erasures-and-errors decoding algorithm for Goppa codes, IBBB Trans. Inform. Theory, 1976, written by Sugiyama, Kasahara, Hirasawa, Namekawa'.

Also, the primitive element of ${\text{GF}}_{\text{b}} {\text{(2}}^{\text{8}} {\text{) = GF}}_{\text{b-B}} {\text{(2}}^{\text{8}} \text{)}$ mentioned above, which is also the root of Gpₐ(x) mentioned previously, is made to be β. This β is (00000010) ^{T} when it is expressed as the linear vector. And the following Equation (42) is concluded from Equation (40).

### [Equation 42]

$\begin{matrix}\begin{matrix}{\text{β}}^{\text{8}} {\text{=β}}^{\text{5}} {\text{+β}}^{\text{3}} {\text{+β}}^{\text{2}} \text{+1} \\ {\text{β}}^{\text{9}} {\text{=β × β}}^{\text{8}} {\text{= β}}^{\text{6}} {\text{+β}}^{\text{4}} {\text{+β}}^{\text{3}} \text{+β} \\ {\text{β}}^{\text{10}} {\text{=βxβ}}^{\text{9}} {\text{=β7+β}}^{\text{5}} {\text{+β}}^{\text{4}} {\text{+β}}^{\text{2}} \\ {\text{β}}^{\text{11}} {\text{=βxβ}}^{\text{10}} {\text{=β}}^{\text{8}} {\text{+β}}^{\text{6}} {\text{+β}}^{\text{5}} {\text{+β}}^{\text{3}} {\text{=β}}^{\text{5}} {\text{+β}}^{\text{3}} {\text{+β}}^{\text{2}} {\text{+1+β}}^{\text{6}} {\text{+β}}^{\text{5}} {\text{+β}}^{\text{3}} {\text{=β}}^{\text{6}} {\text{+β}}^{\text{2}} \text{+1}\end{matrix}\end{matrix}$

When this is expressed as the linear vector, ${\text{(β}}^{\text{8}} {\text{)}}_{\text{b}} \text{= (00101101)T}$.
(x)_{b} here indicates the linear vector expression of the element X of GF_{b}(2⁸) mentioned above. Also, ${\text{(β}}^{\text{0}} {\text{)}}_{\text{b}} {\text{= (1)}}_{\text{b}} {\text{= (00000001)}}^{\text{T}}$.
With regard to the decoding of the RS_{b} code mentioned above, if the Galois field is transformed, it can be realised by performing the transformation of the code formation polynomial expression at the same time, and the transformation itself is also relatively simple.

Next follows the explanation of each composite element of the RS encoding / decoding 101 and the circuit that forms the RS encoding / decoding core section 112, as shown in Diagram 1.

### The Input side transformation circuit and output side transformation circuit

The relationship between α and β can be realised, for example, as shown below. It may be noted that, Gpₐ(x) is the primitive polynomial expression on GF (2), and has 8 roots of
α, α², α⁴, α⁸, α¹⁶, α³², α⁶⁴, α¹²⁸.
Similarly, the primitive polynomial expression Gp_{a - p}(x) that has αₚ as the root, also has total of 8 of α^{2p}, α^{4p}, α^{8p}, α^{16p}, α^{32p}, α^{64p}, α^{128p} apart from α^{p}, and the Equation (43) is concluded.

### [Equation 43]

${\text{G}}_{\text{pa}} \text{-} \text{p} \text{(} \text{x} \text{) = (} \text{x} {\text{+ α}}^{\text{p}} \text{)(} \text{x} {\text{+α}}^{\text{4} \text{p}} \text{)(} \text{x} {\text{+α}}^{\text{8} \text{p}} \text{)...(} \text{x} {\text{+α}}^{\text{64} \text{p}} \text{)(} \text{x} {\text{+α}}^{\text{128} \text{p}} \text{)}$

In the above Equation (43), when p = 241, then Equation (44) is concluded as below.

### [Equation 44]

${\text{G}}_{\text{pa}} {\text{-p(x)=α}}^{\text{0}} {\text{x}}^{\text{8}} {\text{+α}}^{\text{0}} {\text{x}}^{\text{5}} {\text{+α}}^{\text{0}} {\text{x}}^{\text{3}} {\text{+α}}^{\text{0}} {\text{x}}^{\text{2}} {\text{+α}}^{\text{0}}$

Here, on GF(2), α⁰ = 1, therefore the right side of Equation (44) coincides with the right side of Equation (40) shown above. Namely, Gp_{a - p}(x) shown above and Gp_{b}(x) shown above have the same root on the GF (2). Also, when calculating with GFₐ(2⁸) shown above, Equation (45) is concluded.

### [Equation 45]

${\text{G}}_{\text{pb}} {\text{(α}}^{\text{241}} \text{)=0}$

As shown above, α²⁴¹ of the Galois field GFₐ(2⁸) mentioned above, corresponds to β of the Galois field GF_{b}(2⁸) mentioned above. When explained in more detail, Equation (46) below is concluded from Equation (45) shown above.

### [Equation 46]

$\begin{matrix}\begin{matrix}{\text{(α}}^{\text{241}} {\text{)}}^{\text{8}} {\text{= (α}}^{\text{241}} {\text{)}}^{\text{5}} {\text{+(α}}^{\text{241}} {\text{)}}^{\text{3}} {\text{+(α}}^{\text{241}} {\text{)}}^{\text{2}} \text{+1} \\ {\text{(α}}^{\text{241}} {\text{)}}^{\text{9}} {\text{= α}}^{\text{241}} {\text{× (α}}^{\text{241}} {\text{)}}^{\text{8}} {\text{= (α}}^{\text{241}} {\text{)}}^{\text{6}} {\text{+ (α}}^{\text{241}} {\text{)}}^{\text{4}} {\text{+ (α}}^{\text{241}} {\text{)}}^{\text{3}} {\text{+ α}}^{\text{241}} \\ {\text{(α}}^{\text{241}} {\text{)}}^{\text{1}} {\text{° =α}}^{\text{241}} {\text{×(α}}^{\text{241}} {\text{)}}^{\text{9}} {\text{=(α}}^{\text{241}} {\text{)}}^{\text{7}} {\text{+(α}}^{\text{241}} {\text{)}}^{\text{5}} {\text{+(α}}^{\text{241}} {\text{)}}^{\text{4}} {\text{+(α}}^{\text{241}} {\text{)}}^{\text{2}} \\ {\text{(α}}^{\text{241}} {\text{)}}^{\text{11}} {\text{=α}}^{\text{241}} {\text{×(α}}^{\text{241}} {\text{)}}^{\text{10}} {\text{=(α}}^{\text{241}} {\text{)}}^{\text{6}} {\text{+(α}}^{\text{241}} {\text{)}}^{\text{2}} \text{+1}\end{matrix}\end{matrix}$

From the above Equation (46), it becomes possible, with z as the optional integer, to express any element α^{24¹z} of the Galois field GFₐ(2⁸) mentioned above, such as (α²⁴¹)⁷, (α²⁴¹)⁶, ---, (α²⁴¹)², α^{24¹} and the linear combination of 1. In other words, in the case of Equation (47) shown below, the relationship of Equation (48) is concluded.

### [Equation 47]

${\text{β}}^{\text{2}} \text{=} \text{j} \text{=0} \text{7} {\text{B}}_{\text{j}} {\text{β}}^{\text{j}}$

### [Equation 48]

${\text{α}}^{\text{241} \text{z}} \text{=} \text{j} \text{=0} \text{7} {\text{B}}_{\text{z,j}} {\text{α}}^{\text{241}} {\text{}}^{\text{j}}$

With regard to the above Equation (47) and (48), B_{z,i} =0 or 1.
Similarly, on the Galois field GFₐ(2⁸), a^{241z} behaves as if it is
β^{z} on the Galois field GF_{b}(2⁸). On the contrary β^{z} on the Galois field GF_{b}(2⁸) mentioned above, corresponds to α^{241z} of the Galois field GFₐ(2⁸) mentioned above.

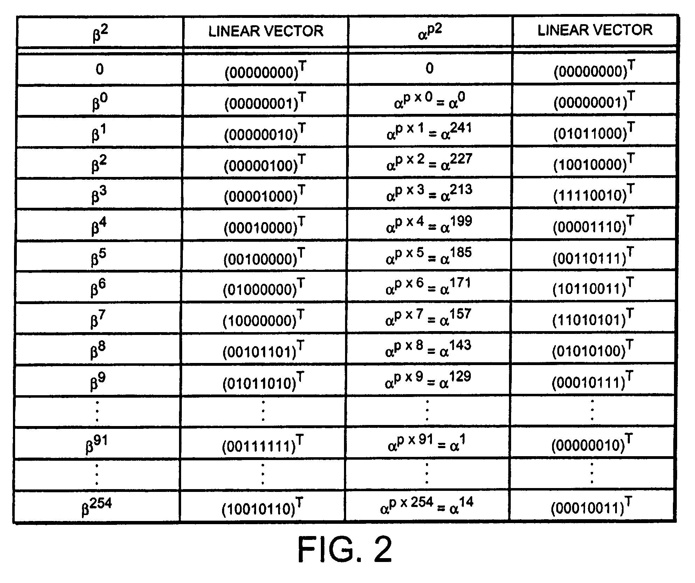

Thus, the input side transformation circuit 116 that transforms to the Galois field ${\text{GF}}_{\text{a}} {\text{(2}}^{\text{8}} {\text{) = GF}}_{\text{b-B}} {\text{(2}}^{\text{8}} \text{)}$ from Galois field ${\text{GF}}_{\text{b}} {\text{(2}}^{\text{8}} {\text{) = GF}}_{\text{b-B}} {\text{(2}}^{\text{8}} \text{)}$ mentioned above, transforms any element β^{z} of GF_{b}(2⁸) into the element α^{24¹z} of GFₐ(2⁸), and also transforms 0 into 0. As the transformed series(system) conforms to the calculation rule of GFₐ(2⁸) mentioned above, it is possible to use one that is defined on the previously mentioned GFₐ(2⁸), as the multiplier in regard to the RS encoding / decoding process which will be explained later. The characteristics of this transformation operation are produced in relation to each vector expression. In the input side transformation circuit 116, the transformation that is shown in the Transformation Table in Diagram 2, is performed on the basis of the Galois field transformation parameter S120a. Also in the output side transformation circuit 119, the transformation that is shown in the Transformation Table in Diagram 2, is performed on the basis of the Galois field transformation parameter S120b.
As shown in the Transformation Table in Diagram 2, the input side transformation circuit 116 outputs 8 bit data that corresponds to each 0, 1, α²⁴¹, α^{241×1}, α^{241×2}, α^{241×3} ---, according to the 8bit address input that corresponds to 0, 1, β¹, β², β³ ---.

Also, the series(system) from the result of the process on the Galois field GFₐ(2⁸) mentioned above, transforms any element α ^{241z} of GFₐ(2⁸) into the GFₐ(2⁸), and also by the output side transformation circuit 119 that transforms 0 into 0, it transforms into the series(system) of the original Galois field GF_{b}(2⁸). As shown in Diagram 2, the output side transformation circuit 119 also outputs 8 bit data that corresponds to 0, 1, β¹, β², β³ ---, in regard to 8bit address input that corresponds to 0, 1, α²⁴¹, α^{241×1}, α^{241×2}, α^{241×3} ---, on the basis of the Galois field transformation parameter S120b.

Also, the following Equation (49) is concluded on the previously mentioned Galois field GF_{b}(2⁸), therefore there are no problems when the Galois field transformation parameters S120a, S120b that correspond to the Transformation Table on Diagram 2, are output from the parameter setting section, with the essentials as shown above

### [Equation 49]

$\text{G} {\text{p}}_{\text{a}} {\text{(β}}^{\text{91}} \text{)=0}$

The previously mentioned Equations (45) and (49) form a pair as they get the same transformation table, but apart from the above, there are a total of 8 sets of pairs, such as Gp_{b}(α³¹) = 0 and Gpₐ(β^{*181*}) = 0 or Gp_{b}(α^{*62*}) = 0 and Gpₐ(β²^{*18*}) = 0, etc.
In the encoding / decoding equipment in this example of the practical application, it is fine to use the Galois field parameters S120a, S120b, which correspond to the transformation table that use any pair.

The transformation of the above Galois field can be described by using the 8 × 8 matrix.
Before explaining its example, the rules of the original transformation is generally explained.

### [Theorem 1]

m × m matrix |Hba(z)|that transforms into the Galois field GFₐ(2^{m}) from the Galois field GF_{b}(2^{m}), is defined by the following equation (50).

### [Equation 50]

${\text{(α}}^{\text{p}} {\text{}}^{\text{2}} {\text{)}}_{\text{a}} \text{=|} {\text{H}}_{\text{ba}} \text{(} \text{z} {\text{)|(β}}^{\text{2}} \text{)} \text{b}$

With regard to the Equation (50) mentioned above, z is an optional integer, and (X)ₐ is the linear vector expression of original element X of the Galois field GFₐ(2^{m}) mentioned above. Similarly, (Y)_{b} is the linear vector expression of the original element Y of the Galois field GF_{b}(2^{m}) mentioned above. That is to say, these are the m × 1 matrix, α is the primitive element of the Galois field GFₐ(2^{m}) mentioned above, and is the root of Gpₐ(x) that is the m-th field formation polynomial expression on GF(2). β is the primitive element of the Galois field GF_{b}(2^{m}) mentioned above, and is the root of Gpₐ(x) that is the m-^{th} field formation polynomial expression on GF(2), and ${\text{(β)}}_{\text{b}} {\text{= (000---010)}}^{\text{T}}$.
Also, on Gpₐ(2^{m}), the following Equation (51) is concluded.

### [Equation 51]

$\text{G} {\text{p}}_{\text{b}} {\text{(α}}^{\text{p}} \text{)=0}$

At this point, the following Equation (52) is concluded.

### [Equation 52]

$\text{|} {\text{H}}_{\text{ba}} \text{(} \text{z} \text{)|=|} {\text{H}}_{\text{ba}} {\text{| = [(α}}^{\text{p}} {\text{}}^{\text{(} \text{m} \text{-1)}} {\text{)}}_{\text{a}} {\text{(α}}^{\text{p}} {\text{}}^{\text{(} \text{m} \text{-2)}} {\text{)}}_{\text{a}} {\text{...(α}}^{\text{2} \text{p}} {\text{)}}_{\text{a}} {\text{(α}}^{\text{p}} {\text{)}}_{\text{a}} {\text{(α}}^{\text{0}} {\text{)}}_{\text{a}} \text{]}$

That is to say, without the value of z, the Equation (50) is concluded, which was shown earlier.
This [Theorem 1] can be explained as shown below.
First of all, from the conclusion of the following Equation (53), Equation (54) is concluded by using the matrix |*H*_{*ba*}| of the previously shown Equation (52).

### [Equation 53]

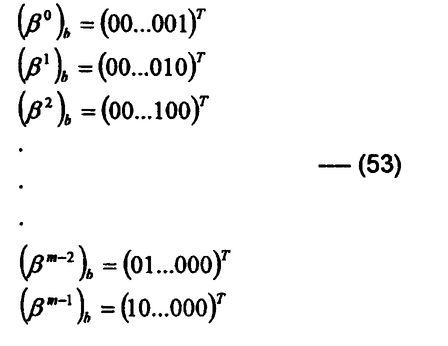

### [Equation 54]

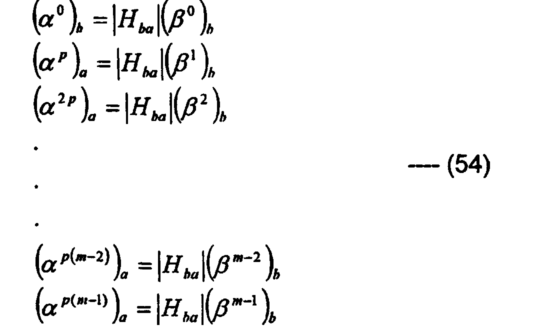

Also, with regard to the optional element β^{z}, the following Equation (55) is concluded.

### [Equation 55]

${\text{β}}^{\text{2}} \text{=} \text{i} \text{=0} \text{m} \text{-1} {\text{B}}_{\text{2,} \text{i}} {\text{β}}^{\text{i}}$

Here, B_{z,i} = 0 or 1, and z is an optional integer. Then, the previously mentioned Equation (56) is concluded, therefore as a result of that, the following Equation (56) is concluded.

### [Equation 56]

${\text{α}}^{\text{p}} {\text{}}^{\text{2}} \text{=} \text{i} \text{=0} \text{m} \text{-1} {\text{B}}_{\text{z,i}} {\text{α}}^{\text{pi}}$

This can be easily analogised even from the previously mentioned Equation (47) and Equation (48). Therefore, with regard to the vector expression of both these sides, the previously shown Equation (54) can be transformed into the following Equation (57).

### [Equation 57]

${\text{(α}}^{\text{p}} {\text{}}^{\text{2}} {\text{)}}_{\text{a}} \text{=} \text{i} \text{=0} \text{m} \text{-1} {\text{B}}_{\text{z,i}} {\text{(α}}^{\text{pi}} {\text{)}}_{\text{a}} \text{=} \text{i} \text{=0} \text{m} \text{-1} {\text{B}}_{\text{z,i}} \text{|} {\text{H}}_{\text{ba}} {\text{|(β}}^{\text{i}} {\text{)}}_{\text{b}} \text{=|} {\text{H}}_{\text{ba}} \text{|} \text{i} \text{=0} \text{m} \text{-1} {\text{B}}_{\text{z,i}} {\text{(β}}^{\text{i}} {\text{)}}_{\text{b}}$

Furthermore, the following Equation (58) can be obtained by the substitution of the vector expression from both sides of the previously mentioned Equation (55) for the above Equation (57).

### [Equation 58]

${\text{(α}}^{\text{pz}} {\text{)}}_{\text{a}} \text{=|} {\text{H}}_{\text{ba}} {\text{|(β}}^{\text{z}} {\text{)}}_{\text{b}}$

Now the proof of [Theorem 1] has been completed.
Also, with regard to the |*H*_{*ba*}|from the previously mentioned Equation (55), the following Equation (59) is concluded in regard to ${\text{(0)}}_{\text{a}} {\text{= (000---000)}}^{\text{T}}$ and ${\text{(0)}}_{\text{b}} {\text{= (000---000)}}^{\text{T}}$.

### [Equation 59]

${\text{(0)}}_{\text{a}} \text{= |} {\text{H}}_{\text{ba}} {\text{| (0)}}_{\text{b}}$

That is to say, it transforms all the elements of the previously mentioned Galois field Gpₐ(2^{m}) into all the elements of the previously mentioned Galois field Gp_{b}(2^{m}).

In conclusion so far, in the case that the number of m,
among relations between 2^{m}'s input and output in the process of transformation of the input side,
-produces the output ${\text{A}}_{\text{0}} {\text{= (00---001)}}^{\text{T}}$ of m bit, in regard to the input (00---0001)^{T} of m bit,
-produces the output A₁ = (A₁, ₘ₋₁, A₁, ₘ₋₂, ---, A₁, ₀)^{T} of m bit, in regard to the input (00-0001)^{T} of the bit,
-produces the output A₂ = (A₂, ₘ₋₁, A₂, ₘ₋₂, ---, A₂, ₀)^{T} of m bit, in regard to the input (00---0001)^{T} of m bit,
-produces the output Aₘ₋₂ = (Aₘ₋₂, ₘ₋₁, Aₘ₋₂, ₘ₋₂, ---, Aₘ₋₂, ₀)^{T} of m bit, in regard to the input (01---0000)^{T} of m bit,
-produce the output Aₘ₋₁= (Aₘ₋₁, ₘ₋₁, Aₘ₋₂, ₘ₋₂, ---, A_{m-1,0})^{T} of m bit, in regard to the input (10---0000)^{T} of m bit,
   then the m×m matrix is regulated as shown in Equation (60) below.

### [Equation 60]

$\text{|} {\text{H}}_{\text{ba}} {\text{|=(A}}_{\text{m-1}} {\text{A}}_{\text{m-2}} {\text{--- A}}_{\text{2}} {\text{A}}_{\text{1}} {\text{A}}_{\text{0}} \text{)}$

And the transformation process of the input side, mentioned above, and m bit Dₐ₋ₒᵤₜ of the output in regard to m bit D_{b-in} of the input, are realised by the process of the calculation that is shown in the following Equation (61).

### [Equation 61]

${\text{D}}_{\text{a-out}} \text{= |} {\text{H}}_{\text{ba}} {\text{| × D}}_{\text{b-in}}$

The input side transformation circuit 116 performs the input side transformation process that was explained above, on the basis of the Galois field transformation parameter 120a.
With regard to the previously shown Equations (49) ∼ (57), the detailed example of the input side transformation circuit 116, when m = 1, q = 1, p = 241, is explained below.
The following Equation (62) is concluded from the Transformation Table in Diagram 2.

### [Equation 62]

$\begin{matrix}\begin{matrix}{\text{(α}}^{\text{0}} {\text{)}}_{\text{a}} \text{=} {\text{A}}_{\text{0}} {\text{= (00000001)}}^{\text{T}} \\ {\text{(α}}^{\text{241}} {\text{)}}_{\text{a}} \text{=} {\text{A}}_{\text{1}} {\text{= (01011000)}}^{\text{T}} \\ {\text{(α}}^{\text{241×2}} {\text{)}}_{\text{a}} \text{=} {\text{A}}_{\text{2}} {\text{= (10010000)}}^{\text{T}} \\ {\text{(α}}^{\text{241×3}} {\text{)}}_{\text{a}} \text{=} {\text{A}}_{\text{2}} {\text{= (11110010)}}^{\text{T}} \\ {\text{(α}}^{\text{241×4}} {\text{)}}_{\text{a}} \text{=} {\text{A}}_{\text{6}} {\text{= (00001110)}}^{\text{T}} \\ {\text{(α}}^{\text{241×5}} {\text{)}}_{\text{a}} \text{=} {\text{A}}_{\text{2}} {\text{= (00110111)}}^{\text{T}} \\ {\text{(α}}^{\text{241×6}} {\text{)}}_{\text{a}} \text{=} {\text{A}}_{\text{6}} {\text{= (10110011)}}^{\text{T}} \\ {\text{(α}}^{\text{241×7}} {\text{)}}_{\text{a}} \text{=} {\text{A}}_{\text{7}} {\text{= (11010101)}}^{\text{T}}\end{matrix}\end{matrix}$

Therefore, the following Equation (63) is concluded from the previously shown Equation (60).

### [Equation 63]

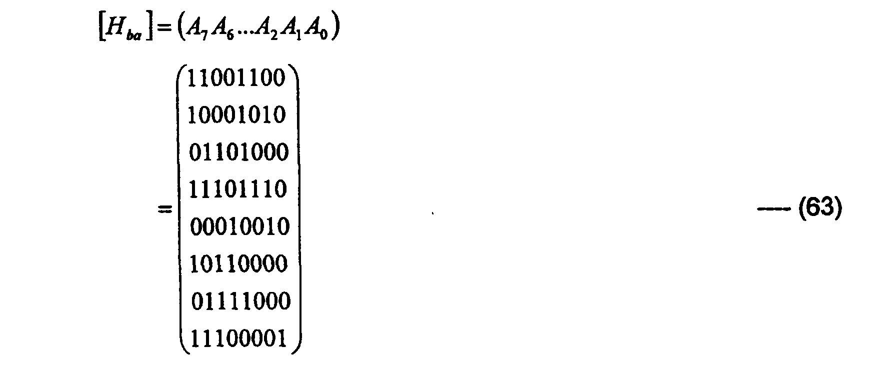

When the relationship between input and output, which is shown in the previously mentioned Equation (61), is expressed in every bit, it is the following Equation (65) as the following Equation (64), therefore the following Equation (66) is concluded.

### [Equation 64]

$\begin{matrix}\begin{matrix}{\text{D}}_{\text{b_in}} \text{= (} {\text{d}}_{\text{b}} {\text{}}_{\text{_} \text{i} \text{7}} {\text{d}}_{\text{b}} {\text{}}_{\text{_} \text{i} \text{6}} {\text{d}}_{\text{b}} {\text{}}_{\text{_} \text{i} \text{5}} {\text{d}}_{\text{b}} {\text{}}_{\text{_} \text{i} \text{4}} {\text{d}}_{\text{b}} {\text{}}_{\text{_} \text{i} \text{3}} {\text{d}}_{\text{b}} {\text{}}_{\text{_} \text{i} \text{2}} {\text{d}}_{\text{b}} {\text{}}_{\text{_} \text{i} \text{1}} {\text{d}}_{\text{b}} {\text{}}_{\text{_} \text{i} \text{0}} {\text{)}}^{\text{T}} \\ {\text{D}}_{\text{a_out}} \text{= (} {\text{d}}_{\text{a}} {\text{}}_{\text{_} \text{o} \text{7}} {\text{d}}_{\text{a}} {\text{}}_{\text{_} \text{o} \text{6}} {\text{d}}_{\text{a}} {\text{}}_{\text{_} \text{o} \text{5}} {\text{d}}_{\text{a}} {\text{}}_{\text{_} \text{o} \text{4}} {\text{d}}_{\text{a}} {\text{}}_{\text{_} \text{o} \text{3}} {\text{d}}_{\text{a}} {\text{}}_{\text{_} \text{i} \text{2}} {\text{d}}_{\text{a}} {\text{}}_{\text{_} \text{o} \text{1}} {\text{d}}_{\text{a}} {\text{}}_{\text{_} \text{o} \text{0}} \text{)}\end{matrix}\end{matrix}$

### [Equation 65]

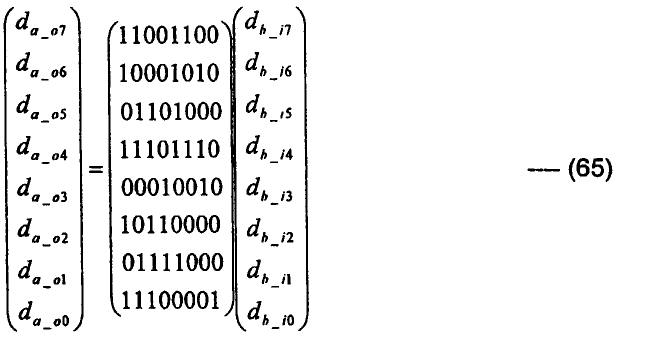

### [Equation 66]

$\begin{matrix}\begin{matrix}{\text{d}}_{\text{a}} {\text{}}_{\text{_} \text{o} \text{7}} \text{=} {\text{d}}_{\text{b}} {\text{}}_{\text{_} \text{i} \text{7}} {\text{XORd}}_{\text{b}} {\text{}}_{\text{_} \text{i} \text{6}} {\text{XORd}}_{\text{b}} {\text{}}_{\text{_} \text{i} \text{3}} {\text{XORd}}_{\text{b}} {\text{}}_{\text{_} \text{i} \text{2}} \\ {\text{d}}_{\text{a}} {\text{}}_{\text{_} \text{o} \text{6}} \text{=} {\text{d}}_{\text{b}} {\text{}}_{\text{_} \text{i} \text{7}} {\text{XORd}}_{\text{b}} {\text{}}_{\text{_} \text{i} \text{3}} {\text{XORd}}_{\text{b}} {\text{}}_{\text{_} \text{i} \text{1}} \\ {\text{d}}_{\text{a}} {\text{}}_{\text{_} \text{o} \text{5}} \text{=} {\text{d}}_{\text{b}} {\text{}}_{\text{_} \text{i} \text{6}} {\text{XORd}}_{\text{b}} {\text{}}_{\text{_} \text{i} \text{5}} {\text{XORd}}_{\text{b}} {\text{}}_{\text{_} \text{i} \text{3}} \\ {\text{d}}_{\text{a}} {\text{}}_{\text{_} \text{o} \text{4}} \text{=} {\text{d}}_{\text{b}} {\text{}}_{\text{_} \text{i} \text{7}} {\text{XORd}}_{\text{b}} {\text{}}_{\text{_} \text{i} \text{6}} {\text{XORd}}_{\text{b}} {\text{}}_{\text{_} \text{i} \text{5}} {\text{XORd}}_{\text{b}} {\text{}}_{\text{_} \text{i} \text{2}} {\text{XORd}}_{\text{b}} {\text{}}_{\text{_} \text{i} \text{2}} {\text{XORd}}_{\text{b}} {\text{}}_{\text{_} \text{i} \text{1}} \\ {\text{d}}_{\text{a}} {\text{}}_{\text{_} \text{o} \text{3}} \text{=} {\text{d}}_{\text{b}} {\text{}}_{\text{_} \text{i} \text{4}} {\text{XORd}}_{\text{b}} {\text{}}_{\text{_} \text{i} \text{1}} \\ {\text{d}}_{\text{a}} {\text{}}_{\text{_} \text{o} \text{2}} \text{=} {\text{d}}_{\text{b}} {\text{}}_{\text{_} \text{i} \text{7}} {\text{XORd}}_{\text{b}} {\text{}}_{\text{_} \text{i} \text{5}} {\text{XORd}}_{\text{b}} {\text{}}_{\text{_} \text{i} \text{4}} \\ {\text{d}}_{\text{a}} {\text{}}_{\text{_} \text{o} \text{1}} \text{=} {\text{d}}_{\text{b}} {\text{}}_{\text{_} \text{i} \text{6}} {\text{XORd}}_{\text{b}} {\text{}}_{\text{_} \text{i} \text{5}} {\text{XORd}}_{\text{b}} {\text{}}_{\text{_} \text{i} \text{4}} {\text{XORd}}_{\text{b}} {\text{}}_{\text{_} \text{i} \text{3}} \\ {\text{d}}_{\text{a}} {\text{}}_{\text{_} \text{o} \text{0}} \text{=} {\text{d}}_{\text{b}} {\text{}}_{\text{_} \text{i} \text{7}} {\text{XORd}}_{\text{b}} {\text{}}_{\text{_} \text{i} \text{6}} {\text{XORd}}_{\text{b}} {\text{}}_{\text{_} \text{i} \text{5}} {\text{XORd}}_{\text{b}} {\text{}}_{\text{_} \text{i} \text{0}}\end{matrix}\end{matrix}$

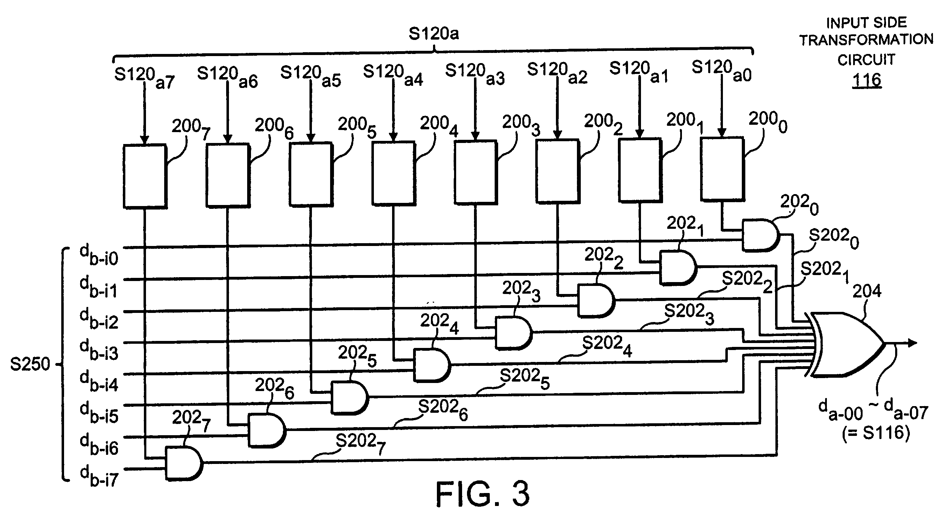

XOR here indicates exclusive disjunction. Therefore, the input side transformation circuit 116 that performs the transformation of the previously mentioned Equation (66), is composed as shown in Diagram 3, for example.

As shown in Diagram 3, the input side transformation circuit 116 has the register 200 ₀∼ 200 ₇, the AND circuit 202 ₀∼ 202 ₇ of 2 input 1 output, and the XOR (exclusive OR : exclusive disjunction) circuit 204.
The register 200 ₀ ∼ 200 ₇ inputs and latches each bit data S120 ₀ ∼ S120 ₇ of the Galois field transformation parameter S120a from the parameter setting section 120, and outputs into one side input terminal of each AND circuit 202 ₀ ∼ 202 ₇.

The AND circuit 202 ₀ ∼ 202 ₇, as described above,
- inputs the bit data S120 ₀ ∼ S120 ₇ from one side input terminal,
- inputs each bit data d ₐ₋ᵢ₀ ∼ d ₐ₋ᵢ₇ of the data S250 that becomes the object of the encoding or decoding, from the other input terminal
- and outputs the data S202 ₀ ∼ S202 ₇ which indicates these conjunctions.

The XOR circuit 204 performs the processing to the exclusive disjunction of the data S202 ₀ ∼ S202 ₇, and outputs the data S116 of the bit data d _{b-i0} ∼ d _{b-i7} which shows its arithmetic results, to the RS encoding / decoding core section 112 that is shown in Diagram 1 in the later part of the document.

The following explanation is about the detailed operation of the input side transformation circuit 116 that is shown in Diagram 3.

### [In the case of performing the RS_{b} encoding and RS_{b} decoding]

In this case, the processing is performed in the input side transformation circuit 116, on the basis of the previously mentioned Equation (65). That is to say,
-first of all, the bit data (1, 0, 0, 0, 0, 1, 1, 1) on the 7^{th} line of the previously mentioned Equation (65) is input, as the bit data (S120_{a 0,} S120ₐ ₁, S120_{a 2}, S120ₐ ₃, S120ₐ ₄, S120_{a 5}, S120_{a 6}, S120ₐ ₇) which composes the Galois field transformation parameter S120ₐ,
-the conjunction (AND) between the relevant bit data (1, 0, 0, 0, 0, 1, 1, 1) and the bit data (d_{b-i0}, d_{b_i1}, d_{b-i2}, d_{b-i3}, d_{b-i4}, d_{b-i5}, d_{b-i6}, d_{b-i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i0}.

Next, the bit data (0, 0, 0, 1, 1, 1, 1, 0) on the 6^{th} line of the previously mentioned Equation (65) is input, as the bit data (S120_{a 0}, S120_{a 1}, S120_{a 2}, S120_{a 3}, S120_{a 4}, S120_{a 5}, S120_{a 6}, S120_{a 7}) which composes the Galois field transformation parameter S120a,
-the conjunction (AND) between the relevant bit data (0, 0, 0, 1, 1, 1, 1, 0) and the bit data (d_{b_i0} , d_{b_i1}, d_{b_i2}, d_{b_i3}, d_{b_i4}, d_{b_i5}, d_{b_i6}, d_{b_i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i1}.

Next, the bit data (0, 0, 0, 0, 1, 1, 0, 1) on the 5^{th} line of the previously mentioned Equation (65) is input, as the bit data (S120_{a 0}, S120ₐ ₁, S120_{a 2}, S120_{a 3}, S120_{a 4}, S120_{a 5}, S120_{a 6}, S120_{a 7}) which composes the Galois field transformation parameter S120ₐ,
-the conjunction (AND) between the relevant bit data (0, 0, 0, 0, 1, 1, 0, 1) and the bit data (d_{b_i0}, d_{b_i1}, d_{b_i2}, d_{b_i3}, d_{b_i4}, d_{b_i5}, d_{b_i6}, d_{b_i7}) are each activated,
-and the data S202 0 ∼ S202 ₇ that indicates the relevant conjunction, are output to the XOR circuit 204.
And the exclusive disjunction is processed in regard to the XOR circuit 204, and its result is output as the data d_{a_i2}.

Next, the bit data (0, 1, 0, 0, 1, 0, 0, 0) on the 4^{th} line of the previously mentioned Equation (65) is input, as the bit data (S120_{a 0}, S120_{a 1}, S120_{a 2}, S120_{a 3}, S120_{a 4}, S120_{a 5}, S120_{a 6}, S120_{a 7}) which composes the Galois field transformation parameter S120ₐ,
-the conjunction (AND) between the relevant bit data (0, 1, 0, 0, 1, 0, 0, 0) and the bit data (d_{b_i0}, d_{b_i1}, d_{b_i2}, d_{b_i3}, d_{b_i4}, d_{b_i5}, d_{b_i6}, d_{b_i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i3}.

Next, the bit data (0, 1, 1, 1, 0, 1, 1, 1) on the 3^{rd} line of the previously mentioned Equation (65) is input, as the bit data (S120_{a 0}, S120_{a 1}, S120_{a 2}, S120_{a 3}, S120_{a 4}, S120_{a 5}, S120_{a 6}, S120_{a 7}) which composes the Galois field transformation parameter S120ₐ,
-the conjunction (AND) between the relevant bit data (0, 1, 1, 1, 0, 1, 1, 1) and the bit data (d_{b_i0}, d_{b_i1}, d_{b_i2}, d_{b_i3}, d_{b_i4}, d_{b_i5}, d_{b_i6}, d_{b_i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i4}.

Next, the bit data (0, 0, 0, 1, 0, 1, 1, 0) on the 2^{nd} line of the previously mentioned Equation (65) is input, as the bit data (S120_{a 0}, S120_{a 1}, S120_{a 2}, S120_{a 3}, S120_{a 4}, S120_{a 5}, S120_{a 6}, S120_{a 7}) which composes the Galois field transformation parameter S120ₐ,
-the conjunction (AND) between the relevant bit data (0, 0, 0, 1, 0, 1, 1, 0) and the bit data (d_{b_i0}, d_{b_i1}, d_{b_i2}, d_{b_i3}, d_{b_i4}, d_{b_i5}, d_{b_i6}, d_{b_i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i5}.

Next, the bit data (0, 1, 0, 1, 0, 0, 0, 1) on the 1^{st} line of the previously mentioned Equation (65) is input, as the bit data (S120_{a 0}, S120_{a 1}, S120_{a 2}, S120_{a 3}, S120_{a 4}, S120_{a 5}, S120_{a 6}, S120_{a 7}) which composes the Galois field transformation parameter S120ₐ,
-the conjunction (AND) between the relevant bit data (0, 1, 0, 1, 0, 0, 0, 1) and the bit data (d_{b_i0}, d_{b_i1}, d_{b_i2}, d_{b_i3}, d_{b_i4}, d_{b_i5}, d_{b_i6}, d_{b_i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i6}.

Next, the bit data (0, 0, 1, 1, 0, 0, 1, 1) on the 0 ^{-th} line of the previously mentioned Equation (65) is input, as the bit data (S120_{a 0}, S120_{a 1}, S120_{a 2}, S120_{a 3}, S120_{a 4}, S120_{a 5}, S120_{a 6}, S120_{a 7}) which composes the Galois field transformation parameter S120ₐ,
-the conjunction (AND) between the relevant bit data (0, 0, 1, 1, 0, 0, 1, 1) and the bit data (d_{b_i0}, d_{b_i1}, d_{b_i2}, d_{b_i3}, d_{b_i4}, d_{b_i5}, d_{b_i6}, d_{b_i7}) are each activated,
-and the data S202 ₀ ∼ S202 ₇ that indicates the relevant conjunction, are output to the XOR circuit 204.
And the exclusive disjunction is processed in regard to the XOR circuit 204, and its result is output as the data d_{a_i7}.
By the above, the processing that is shown in the previously mentioned Equation (65), is completed.

### [In the case of performing the RSₐ encoding]

In this case, with regard to the previously mentioned Equation (65), the unit matrix is used instead of the matrix |*H*_{*ba*}|. And the Galois field transformation parameter S120ₐ that corresponds to the relevant unit matrix, is output into the input side transformation circuit 116 from the parameter setting section 120.
In this case, the data S250 is output as the data S116 as it is, without transformation in regard to the input side transformation circuit 116.

As stated above, the input side transformation circuit 116 can realise the optional matrix arithmetic of 8 × 8, corresponding to the parameters from the parameter setting section 120. Because of that, it is possible to use the common hardware relating to the RS encoding and RS decoding of multiple types. Therefore, the reduction in size and price can be attempted, compared to the case that uses multiple types of hardware that corresponds to the RS encoding and RS decoding of individual types. Also, it is possible to perform the processing at a high speed, as the arithmetic itself is done by hardware.

Next follows the explanation about the output side transformation circuit 119. It is possible to obtain the matrix |*H*_{*ab*}| that corresponds to the output side transformation operation, by the reverse operation from the Transformation Table in Diagram 2, but it is also possible to seek directly from |*H*_{*ba*}| what has already been obtained.
That is to say, in the output side transformation process, the output m bit D_{b_out} that corresponds to the element of Galois field Gp_{b}(2^{m}) mentioned above, is obtained, in regard to the input m bit D_{a_in} that corresponds to the element of the previously mentioned Galois field Gpₐ(2^{m}). There, by exchanging D_{a_out} with Dₐ₋ᵢₙ and exchanging D_{b_in} with D_{b_out} in the generalised Equation (61) mentioned earlier, the following Equation (67)is concluded. Therefore,

### [Equation 67]

${\text{D}}_{\text{a_out}} \text{= |} {\text{H}}_{\text{ba}} {\text{| × D}}_{\text{b_in}}$

It becomes the following Equation (68) by multiplying the reverse matrix |*H*_{*ba*}|⁻¹ of|*H*_{*ba*}|, each from the left side of the previously mentioned Equation (61)'s two sides.

### [Equation 68]

$\text{|} {\text{H}}_{\text{ba}} {\text{|}}^{\text{-1}} {\text{× D}}_{\text{a_in}} \text{=|} {\text{H}}_{\text{ba}} {\text{|}}^{\text{-1}} \text{|} {\text{H}}_{\text{ba}} {\text{|× D}}_{\text{a_out}} {\text{= D}}_{\text{b_out}}$

Therefore, when it is Equation (69) below, the following Equation (70) is concluded.

### [Equation 69]

$\text{|} {\text{H}}_{\text{ab}} \text{|=|} {\text{H}}_{\text{ba}} {\text{|}}^{\text{-1}}$

### [Equation 70]

${\text{D}}_{\text{b_out}} \text{= |} {\text{H}}_{\text{ab}} {\text{|× D}}_{\text{a_in}}$

For a detailed example, the following Equation (71) can be obtained from|*H*_{*ba*}|.

### [Equation 71]

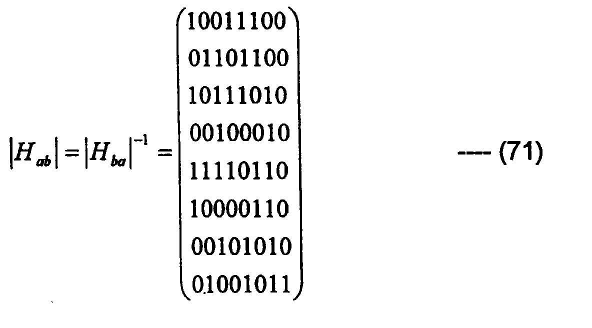

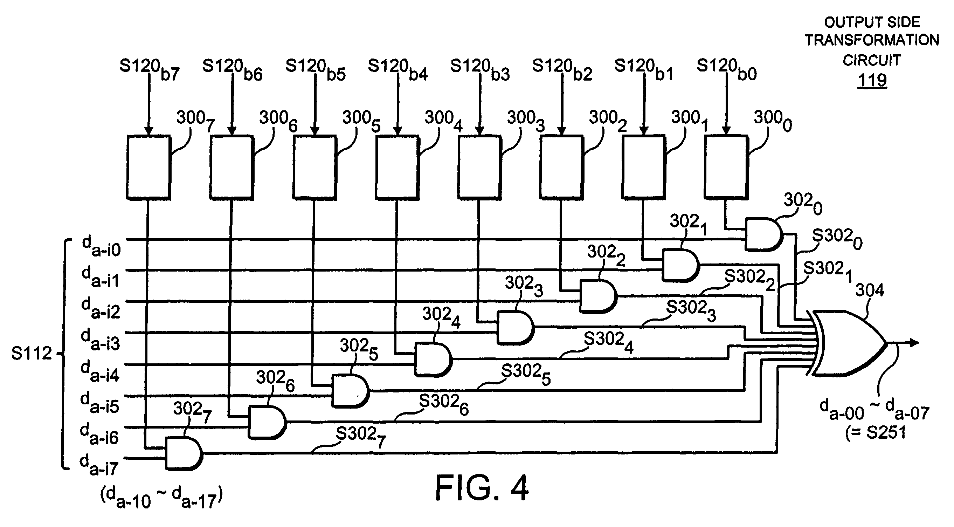

Similarly, the output side transformation circuit 119 can be realised, as shown in Diagram 4, by using the Galois field transformation parameter 120b that corresponds to this matrix |*H*_{*ab*}|.

As shown in Diagram 4, the output side transformation circuit 119 has the register 300 ₀∼ 300 ₇, the AND circuit 302 ₀ ∼ 302 ₇ of 2 input 1 output, and the XOR (exclusive OR : exclusive disjunction) circuit 304.
As shown in Diagram 4, the output side transformation circuit 119 has the same composition as the input side transformation circuit 116 shown in Diagram 3 mentioned earlier.

The register 300 ₀ ∼ 300 ₇ inputs and latches each bit data S120 ₀ ∼ S120 ₇ of the Galois field transformation parameter S120B from the parameter setting section 120, and outputs into one side input terminal of each AND circuit 302 0 ∼ 302 ₇.

The AND circuit 302 ₀ ∼ 302 ₇, as described above,
- inputs the bit data S120 ₀ ∼ S120 ₇ from one side input terminal,
- inputs each bit data d_{a_i0} ∼ d_{a_i7} of the data S250 that becomes the target of the encoding or decoding, from the other input terminal
- and outputs the data S302 ₀ ∼ S302 ₇ which indicates these conjunctions.

The XOR circuit 304 performs the processing to the exclusive disjunction of the data S302 0 ∼ S302 ₇, and outputs the data S116 of the bit data d_{b_i0} ∼ d_{b_i7} which shows its arithmetic results.

The operation of the output side transformation circuit 119 is basically the same as the operation of the input side transformation circuit 116 shown in Diagram 3 mentioned earlier, apart from the content of the Galois field transformation parameter S120_{b} that is input from the parameter setting section 120.
That is to say, the output side transformation circuit 119, in the case of performing the RS_{b} encoding and RS_{b} decoding, inputs the Galois field transformation parameter S120_{b} that corresponds to the matrix |*H*_{*ab*}|shown in Equation (71).
That is to say, at the time of producing the data d_{b_00} - d_{b_07} the process of the multiplication at AND circuit 302 ₀ ∼ 302 ₇ and the exclusive disjunction at XOR circuit 304
are performed by being put in the order of (1, 1, 0, 1, 0, 0, 1, 0) of the 7^{th} line, (0, 1, 0, 1, 0, 1, 0, 0) of the 6^{th} line, (0, 1, 1, 0, 0, 0, 0, 1) of the 5^{th} line, (0, 1, 1, 0, 1, 1, 1, 1) of the 4^{th} line, (0, 1, 0, 0, 0, 1, 0, 0) of the 3^{rd} line, (0, 1, 0, 1, 1, 1, 0, 1) of the 2^{nd} line, (0, 0, 1, 1, 0, 1, 1, 0) of the 1^{st} line, (0, 0, 1, 1, 1, 0, 0, 1) of the 0 -^{th} line,
shown in the previously mentioned Equation (71),
as the bit data (S120_{b0}, S120_{b1}, S120_{b2}, S120_{b3}, S120_{b4}, S120_{b5}, S120_{b6}, S120_{b7}) which compose the Galois field transformation parameter S120_{b} respectively.

On the other hand, with regard to the output side transformation circuit, in the case of performing the RSₐ encoding and RSₐ decoding, the unit matrix is used instead of matrix |*H*_{*ab*}|, and the Galois field transformation parameter 120_{b} that corresponds to the relevant unit matrix, is output into the input side transformation circuit from the parameter setting section.
In this case, the data S112 is output as the data S251 as it is, without transformation in regard to the input side transformation circuit 119.

As stated above, the output side transformation circuit 119 can realise the optional matrix arithmetic of 8 × 8, corresponding to the parameters from the parameter setting section 120. Because of that, it is possible to use the common hardware relating to the RS encoding and RS decoding of multiple types. Therefore, the reduction in size and price can be attempted, compared to the case that uses multiple types of hardware that correspond to the RS encoding and RS decoding of individual types. Also, it is possible to perform the arithmetic at a high speed, as the arithmetic itself is done by hardware.

### RS encoding / decoding core section

The following is the detailed explanation of each circuit that makes up the RS encoding / decoding core section 112.

### [Surplus arithmetic circuit]

The form of practical application of the surplus arithmetic circuit of polynomial expression, which is the elements of major composition for the RS encoding equipment, is shown next. This refers to the case where the RS encoding / decoding core section in Diagram 1 has a function of the RS encoding. With regard to the Galois field multiplier, which makes up the surplus arithmetic circuit of polynomial expression, originally one that corresponds to the RSₐ code, exists. At the time of performing the encoding of the RS_{b} code, the data system D_{a_out} that has been transformed by the input side transformation circuit 116, corresponds to the element of the Galois field Gpₐ(2^{m}), therefore the multiplication of the above Galois field conforms to the multiplication rules on the Gpₐ(2^{m}). Therefore, it is possible to use the identical multiplier even when the encoding of the RS_{b} code is performed.
However, as has been mentioned so far, the element β^{z} of Gp_{b}(2^{m}) corresponds to a^{*pz*} on the Gpₐ(2^{m}), therefore the transformation that is related to the multiplier coefficient on the Gpₐ(2^{m}), becomes necessary. That is to say, with regard to the optional integer u, v, the multiplication of the Galois field on the Gp_{b}(2^{m}), which is shown in the following Equation (72), corresponds to the following Equation (73) on the Gpₐ(2^{m}).

### [Equation 72]

${\text{β}}^{\text{u}} {\text{× β}}^{\text{v}} {\text{=β}}^{\text{u+v}}$

### [Equation 73]

${\text{α}}^{\text{pu}} {\text{× α}}^{\text{pv}} {\text{= α}}^{\text{p(u+v)}}$

Clearly, the division of the Galois field is also the same. Also, with regard to the addition (-subtraction) of the Galois field, referring to the previously mentioned Equations (55) and (56), when it is the following Equation (74), it becomes the Equation (75) on the Gpₐ(2^{m}), shown below.

### [Equation 74]

${\text{β}}^{\text{u}} {\text{+β}}^{\text{v}} \text{=} \text{i} \text{=0} \text{m} \text{-1} {\text{B}}_{\text{u,i}} {\text{α}}^{\text{pi}} \text{+} \text{i} \text{=0} \text{m} \text{-1} {\text{B}}_{\text{v,i}} {\text{β}}^{\text{i}} \text{=} \text{i} \text{=0} \text{m} \text{-1} \text{(} {\text{B}}_{\text{u,i}} \text{+} {\text{B}}_{\text{v,i}} {\text{)β}}^{\text{i}} \text{=} \text{i} \text{=0} \text{m} \text{-1} {\text{B}}_{\text{w,i}} {\text{β}}^{\text{i}} {\text{= β}}^{\text{w}}$

### [Equation 75]

${\text{α}}^{\text{pu}} {\text{+α}}^{\text{pv}} \text{=} \text{i} \text{=0} \text{m} \text{-1} {\text{B}}_{\text{u,i}} {\text{α}}^{\text{pi}} \text{+} \text{i} \text{=0} \text{m} \text{-1} {\text{B}}_{\text{v,i}} {\text{α}}^{\text{pi}} \text{=} \text{i} \text{=0} \text{m} \text{-1} \text{(} {\text{B}}_{\text{u,i}} \text{+} {\text{B}}_{\text{v,i}} {\text{)α}}^{\text{pi}} \text{=} \text{i} \text{=0} \text{m} \text{-1} {\text{B}}_{\text{w,i}} {\text{α}}^{\text{i}} {\text{= α}}^{\text{pw}}$

From the above, even with regard to equality F(x) = 0 that includes any four arithmetical operations of the Galois field, F(β) = 0 on the GF_{b}(2^{m}) corresponds to F(α^{*p*})= 0 on the GFₐ(2^{m}) in general.

### [Equation 76]

${\text{{β}}_{\text{be}} {\text{}}_{\text{[} \text{j} \text{]}} {\text{}={β}}_{\text{be}} {\text{}}_{\text{[0]}} {\text{,β}}_{\text{be}} {\text{}}_{\text{[1]}} {\text{,β}}_{\text{be}} {\text{}}_{\text{[2],..}} {\text{β}}_{\text{be}} {\text{}}_{\text{[} \text{L} \text{-1]}} {\text{,β}}_{\text{be}} {\text{}}_{\text{[} \text{L} \text{]}} \text{}} {\text{={β}}^{\text{e}} {\text{}}^{\text{[0]}} {\text{,β}}^{\text{e}} {\text{}}^{\text{[1]}} {\text{,β}}^{\text{e}} {\text{}}^{\text{[2]}} {\text{,...β}}^{\text{e}} {\text{}}^{\text{[} \text{L} \text{-1]}} {\text{,β}}^{\text{e}} {\text{}}^{\text{[} \text{L} \text{]}} \text{}}$

That is to say, the following Equation (77) is concluded.

### [Equation 77]

${\text{G}}_{\text{cb}} \text{(} \text{x} \text{) =} \text{i} \text{=0} \text{L} \text{(} \text{x} {\text{+ β}}^{\text{q}} {\text{}}^{\text{(} \text{b} \text{+} \text{j} \text{)}} \text{)} {\text{= {β}}^{\text{e}} {\text{}}^{\text{[} \text{L} \text{]}} {\text{x}}^{\text{L}} {\text{+ β}}^{\text{e}} {\text{}}^{\text{[} \text{L} \text{-1]}} {\text{x}}^{\text{L}} {\text{}}^{\text{-1}} {\text{+ ...β}}^{\text{e}} {\text{}}^{\text{[2]}} {\text{x}}^{\text{2}} {\text{+β}}^{\text{e}} {\text{}}^{\text{[1]}} {\text{x}}^{\text{1}} {\text{+β}}^{\text{e}} {\text{}}^{\text{[0]}} {\text{x}}^{\text{0}} \text{}}$

Here, $\text{L=2t-1 or 2t}$. Then, because of the relationship between the previously mentioned Equation and (72) ∼ (75), the sets of the arithmetic coefficient of the Galois field that correspond on the GFₐ(2^{m}), have to be the following Equation (78).

### [Equation 78]

${\text{{α}}_{\text{be}} {\text{}}_{\text{[} \text{i} \text{]}} {\text{}= {α}}_{\text{be}} {\text{}}_{\text{[0]}} {\text{,α}}_{\text{be}} {\text{}}_{\text{[1]}} {\text{,α}}_{\text{be}} {\text{}}_{\text{[2]}} {\text{,...α}}_{\text{be}} {\text{}}_{\text{[} \text{L} \text{-1]}} {\text{α}}_{\text{be}} {\text{}}_{\text{[} \text{L} \text{]}} \text{}} {\text{= {α}}^{\text{pxe}} {\text{}}^{\text{[0]}} {\text{,α}}^{\text{pxe}} {\text{}}^{\text{[1]}} {\text{,α}}^{\text{pxe}} {\text{}}^{\text{[2]}} {\text{,...α}}^{\text{pxe}} {\text{}}^{\text{[} \text{L} \text{-1]}} {\text{,α}}^{\text{pxe}} {\text{}}^{\text{[} \text{L} \text{]}} \text{}}$

At this time, the code formation polynomial expression G_{cba}(x) that corresponds, becomes the following Equation (79).

### [Equation 79]

${\text{G}}_{\text{cba}} \text{(} \text{x} {\text{)=α}}^{\text{pxe}} {\text{}}^{\text{[} \text{L} \text{]}} {\text{x}}^{\text{L}} {\text{+α}}^{\text{pxe}} {\text{}}^{\text{[} \text{L} \text{-1]}} {\text{x}}^{\text{L}} {\text{}}^{\text{-1}} {\text{+...α}}^{\text{pxe}} {\text{}}^{\text{[2]}} {\text{x}}^{\text{2}} {\text{...α}}^{\text{pxe}} {\text{}}^{\text{[1]}} {\text{x}}^{\text{1}} {\text{+α}}^{\text{pxe}} {\text{}}^{\text{[0]}} {\text{x}}^{\text{0}} \text{=} \text{i} \text{=0} \text{L} \text{(} \text{x} {\text{+α}}^{\text{pq}} {\text{}}^{\text{(} \text{b} \text{+} \text{j} \text{)}} \text{)}$

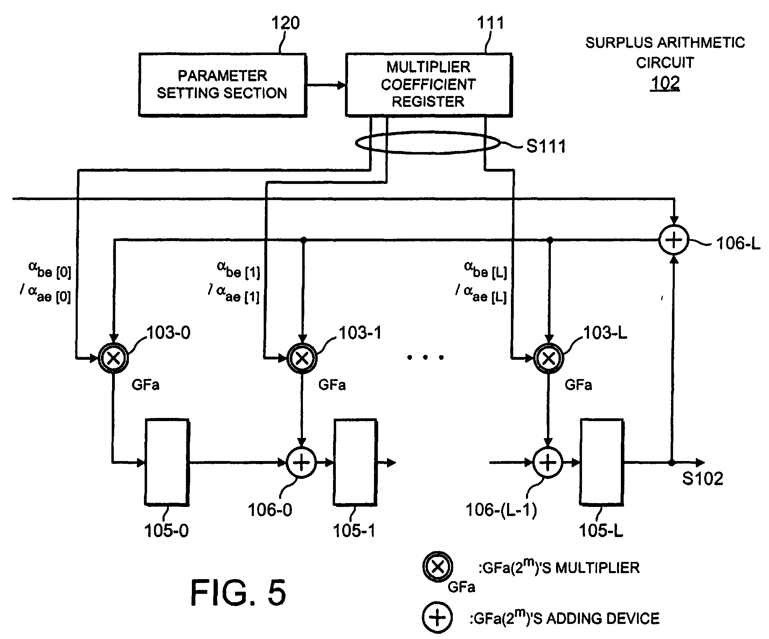

That is to say, in this form of practical application, the surplus arithmetic circuit of polynomial expression installed in the RS encoding equipment that corresponds to two RS codes, becomes as is shown in Diagram5.
As shown in Diagram 5, the surplus arithmetic circuit 102 has the multiplier 103-0∼103-L, the register 105-0∼105-L as well as the adding device 106-0∼106-L. The multiplier 103-0∼103-L selectively inputs the multiplier coefficient {α_{be}[j]}, and the multiplier coefficient {αₐₑ[j]}, from the multiplier coefficient memory section 111, and outputs the relevant multiplication result between the multiplier coefficient that is input, and the input data to the register 105-0∼105-L. In detail, in the case of performing the RSₐ encoding, each multiplier coefficient {αₐₑ[j]} is output to the multiplier 103-0∼103-L by the parameter setting section 120, and the multiplication between the multiplier coefficient {αₐₑ[j]} and the input data is performed. In regard to that, in the case of performing the RS_{b} encoding, each multiplier coefficient {α_{be}[j]} is output to the multiplier 103-0∼103-L by the parameter setting section 120, and the multiplication between the multiplier coefficient {α_{be}[j]} and the input data is performed.

Here, the multiplier coefficient {α_{be}[j]} is the set of the Galois field's multiplier coefficient of the surplus arithmetic of the polynomial expression, which corresponds to the code formation polynomial expression Gcb that is shown in the previous Equation (79). Also, the multiplier coefficient {αₐₑ[j]} is the set of the Galois field's multiplier coefficient of the surplus arithmetic of the polynomial expression, which corresponds to the code formation polynomial expression Gca that is shown in the previous Equation (38). In this Diagram 5, the multiplier 103-0∼103-L of the Galois field is the multiplier on the GFₐ(2^{m}), and the adding device 106-0∼106-L of the Galois field is the adding device on the GFₐ(2^{m}).

Therefore, with regard to the surplus arithmetic circuit of the polynomial expression, which corresponds to the previously mentioned RS_{a_}code that exists originally, the surplus arithmetic circuit of the polynomial expression, which corresponds to the RSₐ code and RS_{b} code, can be realised at the same time only by altering the Galois field's multiplier coefficient. Also, as shown in Diagram 1, even with regard to the encoding of the different RS codes of more than three fields' formation polynomial expression, it is possible to apply this form of practical application, and it is clear that the effect becomes greater as its corresponding number increases. And, in the set {β_{be}[j]) previously mentioned, it can be considered that 0 is also included, but 0^{p} = 0, therefore the element of the set {α_{be}[j]} previously mentioned, which corresponds to this, is of course 0, and the corresponding code formation polynomial expression G_{cba}(x) is of course expressed in the Equation (79) mentioned previously. And this code formation polynomial expression, strictly speaking, is also included in the Goppa codes.
With regard to the detailed example of m = 8, q = 88, p = 24, to make it more detailed, the following Equation (80) and Equation (91) are obtained by substituting b = 120 and L = 15 into the previously mentioned Equation (78).

### [Equation 80]

${\text{G}}_{\text{cb}} \text{(} \text{x} \text{) =} \text{j} \text{=0} \text{15} \text{(} \text{x} {\text{+β}}^{\text{88(120+} \text{j} \text{)}} \text{)} {\text{= β}}^{\text{0}} {\text{x}}^{\text{15}} {\text{+ β}}^{\text{30}} {\text{x}}^{\text{14}} {\text{+ ...β}}^{\text{230}} {\text{x}}^{\text{2}} {\text{+ β}}^{\text{30}} {\text{x}}^{\text{1}} {\text{+ β}}^{\text{0}} {\text{x}}^{\text{0}}$

### [Equation 81]

${\text{{β}}_{\text{be}} {\text{}}_{\text{[} \text{j} \text{]}} {\text{}={β}}^{\text{0}} {\text{,β}}^{\text{30}} {\text{,β}}^{\text{230}} {\text{...β}}^{\text{30}} {\text{,β}}^{\text{0}} \text{}}$

On the other hand, the following Equation (80) and Equation (91) are concluded.

### [Equation 82]

${\text{G}}_{\text{cba}} \text{(} \text{x} \text{)=} \text{j} \text{=0} \text{15} \text{(} \text{x} {\text{+ α}}^{\text{241×88(120+} \text{j} \text{)}} \text{)} {\text{= α}}^{\text{0}} {\text{x}}^{\text{15}} {\text{+α}}^{\text{90}} {\text{x}}^{\text{14}} {\text{+...α}}^{\text{95}} {\text{x}}^{\text{2}} {\text{+α}}^{\text{90}} {\text{x}}^{\text{1}} {\text{+α}}^{\text{0}} {\text{x}}^{\text{0}}$

### [Equation 83]

${\text{{α}}_{\text{be}} {\text{}}_{\text{[} \text{j} \text{]}} {\text{} = {α}}^{\text{0}} {\text{=α}}^{\text{241×0}} {\text{,α}}^{\text{90}} {\text{=α}}^{\text{241×30}} {\text{,α}}^{\text{95}} {\text{=α}}^{\text{24¹×230}} {\text{,...α}}^{\text{90}} {\text{=α}}^{\text{241×30}} \text{}}$

By this means, the previously mentioned Equations (76) ∼ (79) are realised. In this way, in this example of the practical application, it becomes possible to share the Galois field multiplier that has the circuit of a relatively large scale, by each encoding of the RSₐ code and RS_{b} code. To put it concretely, in the conventional technology, in order to perform the encoding of the RS? (* illegible, on the 4^{th} line of [0173] on P058/090) code when $\text{L = 2 t - 1}$, 2 t units of the Galois field's multiplier are required anew. However, in this example of the practical application, it is not necessary to be freshly equipped, and it is sufficient only with the exchange of the Galois field's multiplier coefficient for the division of the polynomial expression. The Galois field's multiplier in the case m = 8, it can be realised with 300 ∼ 400 gates for example. Therefore, when t = 8 in this example, several thousands gates can be economised on by this form of practical application.
And with regard to the addition rules of the Galois field, they are basically the same addition rules, because the field formation polynomial expression on the same GF (2) is the basic field of each Galois field.

### RS decoding

Next, the form of practical application in the case that the RS encoding / decoding core section mentioned above has the decoding function of the RS codes, is explained with Diagram 1. Also in the RS decoding equipment, the transformation circuit of the Galois field is used in the same way with regard to the input and output. Then, later, the RS decoding is composed of the multiplier disjunction of the Galois field, the multiplication of the polynomial type and the division circuit. Therefore, by setting it up after performing the transformation of the Galois field's multiplier coefficient that is the same as RS encoding equipment, the RS decoding equipment that corresponds to more than two RS codes, can be realised together with its Galois field multiplier. That is to say, the multiplier coefficient memory section 111 is equipped with the set {α ? [j]} (* illegible, on the 8^{th} line of [0174] on P059/090) of the Galois field's multiplier coefficient that corresponds to the decoding of the RSₐ code, and the set {α b [j]} of the Galois field's multiplier coefficient that corresponds to the decoding of the RS_{b} code. And by the parameter setting section 120, in the case of performing the decoding of the RSₐ code, the set {α a [i]} of the multiplier coefficient is output to the RS encoding / decoding core section 112 as the multiplier coefficient S111, and in the case of performing the decoding of the RS_{b} code, the set {α b [j]) of the multiplier coefficient is output to the RS encoding / decoding core section 112 as the multiplier coefficient S111.

The decoding of the RSb code is performed on the GFₐ(2^{m}) on the basis of Equation (79) mentioned earlier. That is, strictly speaking, performing the decoding of the Goppa codes, but with regard to its method, for example, the Euclidean decoding method can be applied.

### [Syndrome arithmetic circuit]

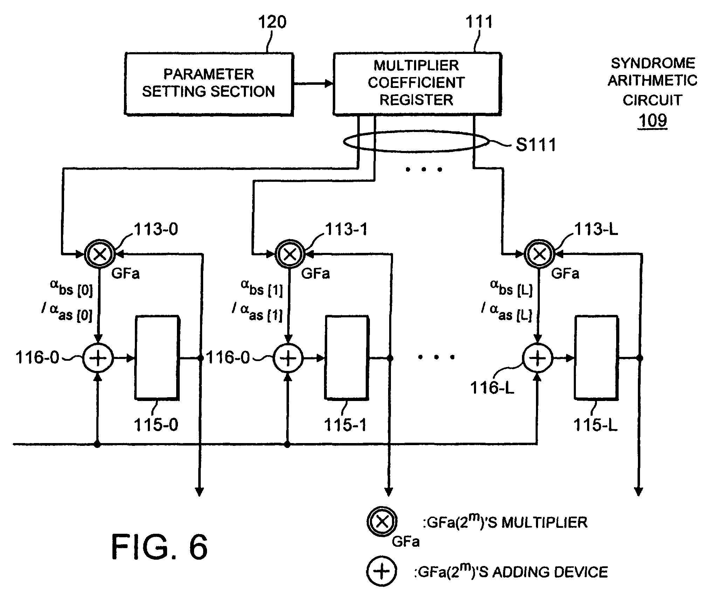

Diagram 6 is the form of the practical application of the syndrome arithmetic circuit that corresponds to the previously mentioned two RS codes. Here, the set {α_{*as*}_{[*i*]}} of the Galois field's multiplier coefficient, $\text{i = 0 ∼ L}$ is included in {α_{a[i]}}, and the set {α_{b[i]}} of the Galois field's multiplier coefficient, $\text{j = 0 ∼ L}$ are included in {α_{b[j]}}. In addition, with regard to the RS_{b} code, the detailed example, when m = 8, q = 88, p = 241, b = 120, L = 15, is shown in Equation (84).

### [Equation 84]

${\text{{α}}_{\text{bs}} {\text{}}_{\text{[} \text{j} \text{]}} {\text{}={α}}_{\text{bs}} {\text{}}_{\text{[0]}} {\text{,α}}_{\text{bs}} {\text{}}_{\text{[1]}} {\text{,α}}_{\text{bs}} {\text{}}_{\text{[2]}} {\text{,...α}}_{\text{bs}} {\text{}}_{\text{[} \text{L} \text{-1]}} {\text{,α}}_{\text{bs}} {\text{}}_{\text{[} \text{L} \text{]}} \text{,}} {\text{= {α}}^{\text{241×88×120}} {\text{,α}}^{\text{241×88×121}} {\text{,α}}^{\text{241×88×122}} {\text{,...α}}^{\text{241×88×134}} {\text{,α}}^{\text{241×88×135}} \text{}} {\text{= {α}}^{\text{50}} {\text{,α}}^{\text{103}} {\text{,α}}^{\text{146}} {\text{,...α}}^{\text{152}} {\text{,α}}^{\text{195}} \text{}}$

As shown in Diagram 6, the syndrome arithmetic circuit 109 has the multiplier 113-0∼113-L, the register 115-0∼115-L and the adding device 116-0∼116-L. The multiplier 113-0∼113-L selectively inputs the multiplier coefficient {α_{bs[j]}} and the multiplier coefficient {α_{as[j]}}, from the multiplier coefficient memory section 111, corresponding to the control by the parameter setting section 120, and outputs the multiplication result between this selected multiplier coefficient and the data from the register 115-0∼115-L, to the adding device 116-0∼116-L. In detail, when performing the RSₐ encoding, each multiplier coefficient {α_{as[j]}} is output to the multiplier 113-0∼113-L from the multiplier 113-0∼113-L, and the multiplication between the multiplier coefficient {α_{as[j]}} and the input data from the register 115-0∼115-L is performed. In regard to that, when performing the RS_{b} encoding, each multiplier coefficient {α_{bs[j]}} is output to the multiplier 113-0∼113-L from the multiplier coefficient memory section 111, and the multiplication between the multiplier coefficient {α_{bs[j]}} and the input data from the register 115-0∼115-L is performed.

Here, the multiplier coefficient {αₐₛ[j]} is the set of the Galois field's multiplier coefficient of the syndrome arithmetic,
which corresponds to the RS_{sb}. Also, the multiplier coefficient {α_{bc[j]}} is the set of the Galois field's multiplier coefficient of the syndrome arithmetic, which corresponds to the RS_{b}. In this Diagram 6, the multiplier 113-0∼113-L of the Galois field is the multiplier on the GFₐ(2^{m}), and the adding device 116-0∼116-L of the Galois field is the adding device on the GFₐ(2^{m}).

### [The division circuit of polynomial expression]

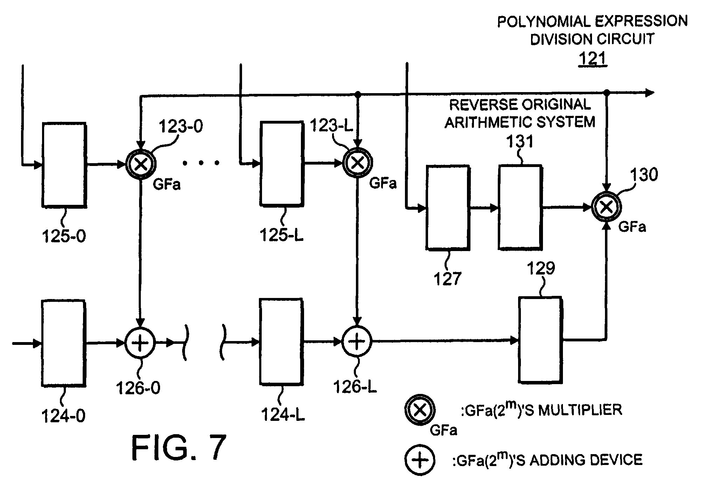

Diagram 7 is the form of practical application of the division circuit 121 of polynomial expression, which is one of the elements in the major composition of the error location polynomial expression and the evaluation polynomial expression arithmetic circuit, which correspond to the previously mentioned two RS codes.
As shown in Diagram 7, the division circuit 121 of polynomial expression has the multiplier 123-0∼133-L, the register 124-0∼124-L, the register 125-0∼125-L, the register 1297, 129, the adding device 126-0∼126-L, the multiplier adding device 130 and the reverse original arithmetic circuit 131.
Here, as you can see by comparing with the conventional polynomial expression division circuit as shown in Diagram 14, the exchange of the Galois field's multiplier is not necessary. Also, it functions well with only one reverse original arithmetic circuit. In other words, when the correction capability with regard to the previously mentioned two RS codes are the same, it can be realised with totally identical circuit.

### [The multiplier circuit of polynomial expression]

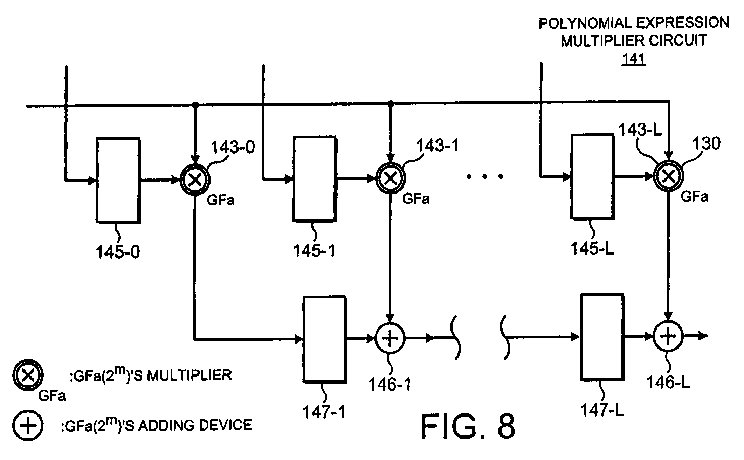

Diagram 8 is an example of the practical application of the multiplier circuit 141 of polynomial expression, which is one of the elements in the major composition of the error location polynomial expression and the evaluation polynomial expression arithmetic circuit, which correspond to the previously mentioned two RS codes.
As shown in Diagram 8, the multiplier circuit 141 of polynomial expression has the multiplier 143-0∼143-L, the register 145-0∼145-L, the adding device 146-0∼146-L and the register 147-0∼147-L.
According to the multiplier circuit 141 of polynomial expression, the multiplication is performed totally by the multiplication rules of Gpₐ(2^{m}), therefore, in the case that the correction capability of the previously mentioned two RS codes are the same, compared to the conventional multiplier circuit of polynomial expression, which is shown in Diagram 15, it is possible to reduce the number of Galois field multipliers to half.

### [The error location detection circuit]

In the past, according to the (Chien Search's algorithm), for the detection of the error location, β^{-qk} that corresponds to the location k, there is introduced gradually to the error location polynomial expression α_{b(x)} shown in Equation (85) that is sought by the error location polynomial expression arithmetic circuit mentioned earlier, and when its value becomes 0 as shown in Equation (86) below, it is judged that there is an error on the location k mentioned previously. Here, in the case of performing the erasure correction, $\text{n = 2 t}$, and when the erasure correction is performed $\text{n = t}$.

### [Equation 85]

${\text{σ}}_{\text{b}} \text{(} \text{x} {\text{)=σ}}_{\text{b}} {\text{}}_{\text{[} \text{n} \text{]}} {\text{x}}^{\text{n}} {\text{+σ}}_{\text{b}} {\text{}}_{\text{[} \text{n} \text{-1]}} {\text{x}}^{\text{n}} {\text{}}^{\text{-1}} {\text{+...σ}}_{\text{b}} {\text{}}_{\text{[2]}} {\text{x}}^{\text{2}} {\text{+σ}}_{\text{b}} {\text{}}_{\text{[1]}} {\text{x}}^{\text{1}} {\text{+σ}}_{\text{b}} {\text{}}_{\text{[0]}} {\text{x}}^{\text{0}}$

### [Equation 86]

${\text{σ}}^{\text{b}} {\text{(β}}^{\text{-} \text{qk}} \text{)=0}$

In this example of the practical application, β^{qk} that corresponds to the error location k mentioned earlier, is equivalent to α ^{? (-?k)} (* illegible, on the 2^{nd} line of [0185] on P062/090) on the Galois field Gpₐ(2^{m}), and there is a relation of the previously mentioned Equation (72) ∼ (75) with regard to the four arithmetical operations, therefore the error location polynomial expression in this form of practical application is shown in the following Equation (87).

### [Equation 87]

${\text{σ}}_{\text{b}} \text{(} \text{x} {\text{)=+σ}}_{\text{n}} {\text{x}}^{\text{n}} {\text{+σ}}_{\text{n}} {\text{}}_{\text{-1}} {\text{x}}^{\text{n}} {\text{}}^{\text{-1}} {\text{+...+σ}}_{\text{2}} {\text{x}}^{\text{2}} {\text{+σ}}_{\text{1}} {\text{x}}^{\text{1}} {\text{+σ}}_{\text{0}} {\text{x}}^{\text{0}}$

Here, when the coefficient of the Galois field GF_{b}(2^{m}) in the previous Equation (86), is ${\text{σ}}_{\text{b[j]}} {\text{= β}}^{\text{c[j]}}$ or 0, the coefficient of the Galois field GFₐ(2^{m}) in the previous Equation (86), is ${\text{σ}}^{\text{j}} {\text{= α}}^{\text{pc[j]}}$ or 0.

### [Equation 88]

${\text{σ(α}}^{\text{-} \text{pqk}} \text{)=0}$

That is to say, in this form of practical application, the error exists on the location k where Equation (88) is completed. And even if one considers performing the decoding of the Goppa codes which are from the code formation polynomial expression of the previously mentioned Equation (79), by the method that is stated in the document mentioned above, the same conclusion is obtained.

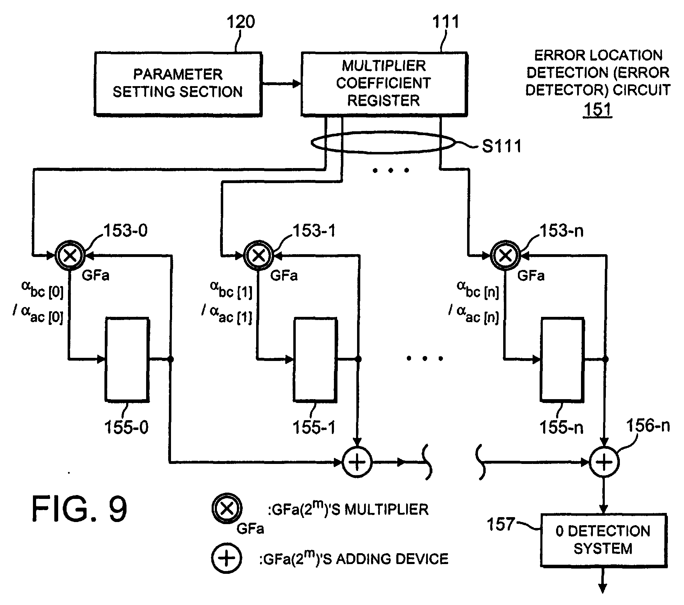

Diagram 9 is the composition drawing of the error location detection circuit 151 related to this example of the practical application, which corresponds to the previously mentioned two RS codes. The error location detection circuit 151 realises Chien Search's algorithm, corresponding to the previously mentioned Equation (87). In this way, it is possible to correspond to the previously mentioned two RS codes only by exchanging the coefficient. Here, when the erasure is not corrected, $\text{n = t}$, and the set of the Galois field's multiplier coefficient, {α_{ae[i]}}, $\text{i = 0 ∼ t}$ is included to the previously mentioned {α_{a[i]}}, also the set of the Galois field's multiplier coefficient, {α_{bc[i]}}, $\text{i = 0 ∼ t}$ is included to the previously mentioned {α_{b[j]}}.

As shown in Diagram 9, the error location detection circuit 151 has the multiplier 153-0∼153-n, the register 155-0∼155-n, the adding device 156-0∼156-n and the 0 - detection circuit 157. In the error location detection circuit 151, the error location k can be sought on the basis of the detection result from the 0 - detection circuit 157.
Here, the multiplier 153-0∼153-n is the multiplier of GFₐ(2^{m}) and the adding device 156-0∼156-n is the adding device of GFₐ(2^{m}).

Furthermore, with regard to the detailed example that applies m = 8, q = 88, p = 241, b = 120, L = 15 (t = 8) in regard to the RSb code, the following Equation (89) is completed.

### [Equation 89]

${\text{{α}}_{\text{bc}} {\text{}}_{\text{[} \text{j} \text{]}} {\text{}={α}}_{\text{bc}} {\text{}}_{\text{[0]}} {\text{,α}}_{\text{bc}} {\text{}}_{\text{[1]}} {\text{,α}}_{\text{bc}} {\text{}}_{\text{[2]}} {\text{,...α}}_{\text{bc}} {\text{}}_{\text{[} \text{n} \text{-1]}} {\text{,α}}_{\text{bc}} {\text{}}_{\text{[} \text{n} \text{]}} \text{}} {\text{= {α}}^{\text{241×88×255}} {\text{,α}}^{\text{241×88×254}} {\text{,α}}^{\text{241×88×253}} {\text{,...α}}^{\text{241×88×246}} {\text{,α}}^{\text{241×88×247}} \text{}}$

By setting the coefficient σ₀ ∼ σₙ of the previously mentioned Equation (87) as the initial value of each register, the value which is equivalent to the left side of the previously mentioned Equation (88) that successively corresponds to k = 0, 1, 2 ---, can be calculated. And when the erasure correction is performed by the RS_{b} code, $\text{j = 0∼2 t}$ (i.e. n = 2 t).

Also in this case, when the RSₐ decoding is performed by the control from the parameter setting section 120, the multiplier coefficient α_{ac[I]} is output to the multiplier 153-0∼153-n from the multiplier coefficient memory section 111. And when the RS_{b} decoding is performed, the multiplier coefficient α_{bc[I]}, on the last line)is output to the multiplier 153-0∼153-n from the multiplier coefficient memory section 111.

### [Evaluation value detection circuit]

In order to correct the error, besides the location of the error, it is necessary to obtain the size C k of the error. The evaluation exponent is the following Equation (90).

### [Equation 90]

$\text{η(} \text{x} {\text{)=η}}_{\text{n}} {\text{}}_{\text{-1}} {\text{x}}^{\text{n}} {\text{}}^{\text{-1}} {\text{+η}}_{\text{n}} {\text{}}_{\text{-2}} {\text{x}}^{\text{n}} {\text{}}^{\text{-2}} {\text{+...+η}}_{\text{2}} {\text{x}}^{\text{2}} {\text{+η}}_{\text{1}} {\text{x}}^{\text{1}} {\text{+η}}_{\text{0}} {\text{x}}^{\text{0}}$

Also, when it is decided to perform the decoding of the Goppa codes, that is the code formation polynomial expression of the previously mentioned Equation (79), making the leading function of the previously mentioned location polynomial expression as σ' (x), according to the document stated above, the previously mentioned size of error can be indicated in the following Equation (91).

### [Equation 91]

${\text{e}}_{\text{k}} \text{=} \frac{{\text{α}}^{\text{pq} \text{(} \text{b} \text{-1)(-} \text{k} \text{)}} {\text{η(α}}^{\text{-} \text{pqk}} \text{)}}{{\text{σ'(α}}^{\text{-} \text{pqk}} \text{)}}$

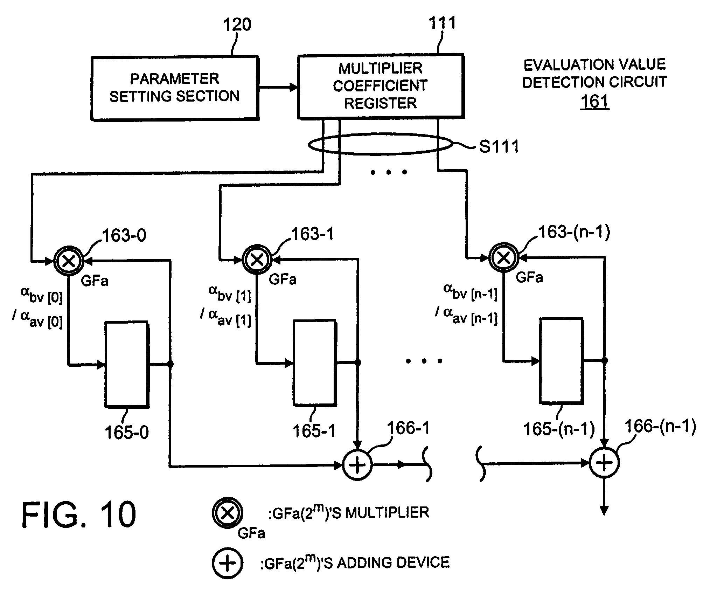

Diagram 10 is an example of the practical application of the concept of the evaluation value detection circuit that corresponds to the previously mentioned two RS codes.
As shown in Diagram 10, the evaluation value detection circuit 161 has the multiplier 163-0∼163-(n - 1), the register 165-0∼165-(n - 1), and the adding device 166-0∼166-(n - 1).
Here, when the erasure is not corrected, $\text{n = t}$, and the set of the Galois field's multiplier coefficient, {α_{av[i]}}, $\text{i = 0 ∼ t}$ is included in the previously mentioned {α[I]}, also the set of the Galois field's multiplier coefficient, {α_{bv[j]}}, $\text{j = 0 ∼ t - 1}$ is included in the previously mentioned {α_{b[J]}}.

The multiplier 163-0∼163-(n - 1) selectively inputs the multiplier coefficient {α_{bv[j]}} and the multiplier coefficient {α_{av[j]}}, from the multiplier coefficient memory section 111, corresponding to the control by the parameter setting section 120, and outputs the multiplication result between this selected multiplier coefficient and the data from the register 165-0∼165-(n - 1). In detail, when performing the RSₐ decoding, each multiplier coefficient {α_{av[j]}} is output to the multiplier 163-0∼163-(n - 1), and the multiplication between the multiplier coefficient {α_{av[j]}} and the input data from the register 165-0∼165-(n - 1) is performed. With regard to that, in the case of performing the RS_{b} decoding, each multiplier coefficient {α_{bv[j]}} is output to the multiplier 163-0∼163-(n - 1), and the multiplication between the multiplier coefficient {α_{bv[j]}} and the input data from the register 165-0∼165----(n - 1) is carried out.

Furthermore, with regard to the detailed example that applies m = 8, q = 88, p = 241, b = 120, L = 15 (t = 8) in regard to the RS_{b} code, the following Equation (92) is completed.

### [Equation 92]

${\text{{α}}_{\text{bv}} {\text{}}_{\text{[j]}} {\text{}={α}}_{\text{bv}} {\text{}}_{\text{[0]}} {\text{,α}}_{\text{bv}} {\text{}}_{\text{[1]}} {\text{,α}}_{\text{bv}} {\text{}}_{\text{[2]}} {\text{,...α}}_{\text{bv}} {\text{}}_{\text{[} \text{t} \text{-2]}} {\text{,α}}_{\text{bv}} {\text{}}_{\text{[} \text{t} \text{-1]}} \text{}} {\text{= {α}}^{\text{241×88×255}} {\text{,α}}^{\text{241×88×254}} {\text{,α}}^{\text{241×88×253}} {\text{,...α}}^{\text{241×88×249}} {\text{,α}}^{\text{241×88×248}} \text{}}$

By setting the coefficient η₀ ∼ ηₜ₋₁ of the previously mentioned Equation (87) as the initial value of each register, it is possible to obtain the value of η (α^{-pqk}) of the previously mentioned Equation (91) successively, which corresponds to k = 0, 1, 2---.

Or, as the value of the numerator of the previously mentioned Equation (91) is indicated by the following Equation (93), therefore,

### [Equation 93]

${\text{α}}^{\text{pq}} {\text{}}^{\text{(} \text{b} \text{-1)(-} \text{k} \text{)}} {\text{η(α}}^{\text{-} \text{pqk}} {\text{)=α}}^{\text{pq}} {\text{}}^{\text{(} \text{b} \text{-1)(-} \text{k} \text{)}} {\text{{η}}_{\text{t}} {\text{}}_{\text{-1}} {\text{α}}^{\text{-} \text{pqk} \text{(} \text{t} \text{-1)}} {\text{+η}}_{\text{t}} {\text{}}_{\text{-2}} {\text{α}}^{\text{-} \text{pqk} \text{(} \text{t} \text{-2)}} {\text{+...+η}}_{\text{2}} {\text{α}}^{\text{-} \text{pqk} \text{×2}} {\text{η}}_{\text{1}} {\text{α}}^{\text{-} \text{pqk}} {\text{+η}}_{\text{0}} \text{}} {\text{=η}}_{\text{t}} {\text{}}_{\text{-1}} {\text{α}}^{\text{-} \text{pq} \text{(} \text{t} \text{+} \text{b} \text{-2)} \text{k}} {\text{+η}}_{\text{2}} {\text{α}}^{\text{-} \text{pq} \text{(} \text{t} \text{+} \text{b} \text{-3)} \text{k}} {\text{+ ...+η}}_{\text{2}} {\text{α}}^{\text{-} \text{pq} \text{(} \text{b} \text{+} \text{I} \text{)} \text{k}} {\text{+η}}_{\text{1}} {\text{α}}^{\text{-} \text{pqk}} {\text{+η}}_{\text{0}} {\text{α}}^{\text{-} \text{pq} \text{(} \text{b} \text{-1)} \text{k}}$

With regard to the detailed example that m = 8, q = 88, p = 241, b = 120, L = 15(t = 8) in regard to the RS_{b} code, as the following Equation (94),

### [Equation 94]

${\text{{α}}_{\text{bv}} {\text{}}_{\text{[} \text{j} \text{]}} {\text{}=α}}_{\text{bv}} {\text{}}_{\text{[0]}} {\text{,α}}_{\text{bv}} {\text{}}_{\text{[1]}} {\text{,α}}_{\text{bv}} {\text{}}_{\text{[2]}} {\text{,...α}}_{\text{bv}} {\text{}}_{\text{[} \text{t} \text{-2]}} {\text{,α}}_{\text{bv}} {\text{}}_{\text{[} \text{t} \text{-1]}} \text{}} {\text{={α}}^{\text{241×88×(255-119)}} {\text{,α}}^{\text{241×88×(254-119)}} {\text{,α}}^{\text{241×88×(253-119)}} {\text{,...α}}^{\text{241×88×(249-119)}} {\text{,α}}^{\text{241×88×(248-119)}} \text{}}$

the value of the numerator of Equation (91) mentioned above can be successively obtained. Furthermore, by using the fact that the leading function σ' (x) of the previously mentioned polynomial expression and the polynomial expression σ_{odd} (x) of the disjunction of the odd number next clause of the previously mentioned location polynomial expression, is the following Equation (95),

### [Equation 95]

$\text{σ'(} \text{x} \text{)=} \text{x} {\text{σ}}_{\text{odd}} \text{(} \text{x} \text{)}$

The previously mentioned Equation (91) is transformed into the following Equation (96).

### [Equation 96]

${\text{e}}_{\text{k}} \text{=} \frac{{\text{α}}^{\text{pq} \text{(} \text{b} \text{-1)(-} \text{k} \text{)}} {\text{η(α}}^{\text{-} \text{pqk}} \text{)}}{{\text{σ'(α}}^{\text{-} \text{pqk}} \text{)}} \text{=} \frac{{\text{α}}^{\text{pq} \text{(} \text{b} \text{-1)(-} \text{k} \text{)}} {\text{η(α}}^{\text{-} \text{pqk}} \text{)}}{{\text{α}}^{\text{-} \text{pqbk}} {\text{σ}}_{\text{odd}} {\text{(α}}^{\text{-} \text{pqk}} \text{)}} \text{=} \frac{{\text{α}}^{\text{-} \text{pqk}} {\text{η(α}}^{\text{-} \text{pqk}} \text{)}}{{\text{σ}}_{\text{odd}} {\text{(α}}^{\text{-} \text{pqk}} \text{)}}$

The value of this denominator can be simply obtained by the previously mentioned Equation (88) during the process of the detection of the error location, therefore it is more efficient. The value of the denominator of Equation (96) mentioned above is shown in the following Equation (97), therefore,

### [Equation 97]

${\text{α}}^{\text{-} \text{pqk}} {\text{η(α}}^{\text{-} \text{pqk}} {\text{)=α}}^{\text{pq}} {\text{}}^{\text{(} \text{b} \text{-1(-} \text{k} \text{)}} {\text{{η}}_{\text{t}} {\text{}}_{\text{-1}} {\text{α}}^{\text{-} \text{pqk} \text{(} \text{t} \text{-1)}} {\text{+η}}_{\text{t}} {\text{}}_{\text{-2}} {\text{α}}^{\text{-} \text{pqk} \text{(} \text{t} \text{-2)}} {\text{+...+η}}_{\text{2}} {\text{α}}^{\text{-} \text{pqk} \text{×2}} {\text{η}}_{\text{1}} {\text{α}}^{\text{-} \text{pqk}} {\text{+η}}_{\text{0}} \text{}} {\text{= η}}_{\text{t}} {\text{}}_{\text{-1}} {\text{α}}^{\text{-} \text{pq} \text{(} \text{t} \text{+} \text{b} \text{-1)} \text{k}} {\text{+η2α}}^{\text{-} \text{pq} \text{(} \text{t} \text{+} \text{b} \text{-2)} \text{k}} {\text{+ ...+η}}_{\text{2}} {\text{α}}^{\text{-} \text{pq} \text{(} \text{b} \text{+2)} \text{k}} {\text{+η}}_{\text{1}} {\text{α}}^{\text{-} \text{pq} \text{(} \text{b} \text{+1)} \text{k}} {\text{+η}}_{\text{0}} {\text{α}}^{\text{-} \text{pqbk}}$

With regard to the detailed example where m = 8, q = 88, p = 241, b = 120, L = 15(t = 8) in regard to the RS_{b} code, as the following Equation (98),

### [Equation 98]

${\text{{α}}_{\text{bv}} {\text{}}_{\text{[} \text{j} \text{]}} {\text{}={α}}_{\text{bv}} {\text{}}_{\text{[0]}} {\text{,α}}_{\text{bv}} {\text{}}_{\text{[1]}} {\text{,α}}_{\text{bv}} {\text{}}_{\text{[2]}} {\text{,...α}}_{\text{bv}} {\text{}}_{\text{[} \text{t} \text{-2]}} {\text{,α}}_{\text{bv}} {\text{}}_{\text{[} \text{t} \text{-1]}} \text{}} {\text{= {α}}^{\text{241×88×(255-120)}} {\text{,α}}^{\text{241×88×(254-120)}} {\text{,α}}^{\text{241×88×(253}} {\text{-}}^{\text{120)}} {\text{,...α}}^{\text{241×88×(249-120)}} {\text{,α}}^{\text{241×88×(248-120)}} \text{}}$

The value of the denominator of Equation (96) can be successively obtained.

As explained so far, according to the RS encoding / decoding equipment 101, it is possible to perform the RS encoding / decoding on a single Galois field by the original transformation. As a result, it is possible to reduce the numbers of the multiplier and the reverse original arithmetic circuit, and so it is possible to attempt the reduction both in the size of the equipment and the manufacturing cost.
That is to say, the input side transformation circuit 116 and the output side transformation circuit 119 can realise any optional matrix arithmetic of 8 × 8, corresponding to the parameters from the parameter setting section 120. Because of that, it is possible to use the common hardware relating to the RS encoding and RS decoding of multiple types. Therefore, the reduction in size and price can be attempted, compared to the case that uses multiple types of hardware that corresponds to the RS encoding and RS decoding of individual types. And in the case of altering the applied matrix arithmetic expression, it can be smoothly handled. Also, it is possible to perform the processing at a high speed, as the arithmetic itself is done by hardware.

Also, with regard to the surplus arithmetic circuit 102, shown in Diagram 5, the syndrome arithmetic circuit 109 shown in Diagram 6, the error location detection circuit 151 shown in Diagram 9 and the evaluation value detection circuit 161 shown in Diagram 10, there is no need to install the switching circuit that switches the multiplier coefficient to each circuit, as the multiplier coefficient that has been determined on the basis of the control from the parameter setting section 120, is read out from the multiplier coefficient memory section 111 and is output to the multiplier. And it is possible to attempt the simplification of the layout and the reduction in size for the whole RS encoding / decoding equipment.

This invention is not limited only to the form of the practical application stated above.
For example, in the above example of the practical application, it is explained using the RSa code that has the same correction capability as the RSa code, but it can be different. When the circuit is adjusted to one that has a higher correction capability, it is clearly possible to be set up so that the other side uses that one side. Also, it does not matter when the RSa code is the Goppa code. In other words, the required condition for the RSa code and the RSb code is that the degree of each field formation polynomial expression is equal to each other.

Also, with regard to the above form of the practical application of the RS decoding, the Euclidean decoding method was used for the explanation, but this invention is not restricted only to the above. Regarding this, it has been generalised and proven that the series after the Galois field transformation is equivalent to the RS codes (Goppa codes) which correspond to the code formation polynomial expression of Equation (27) mentioned above, therefore the well-known RS decoding method (the Goppa decoding method or BCH decoding method, that has a higher class than the former) can be applied.

And it is possible to reduce the scale of the circuit by selecting one whose multiplication amount is minimal, as the field formation polynomial expression of the specific RSa code.

### [The effectiveness of the invention]

As explained above, according to the Reed Solomon encoding equipment and its operation in embodiments of this invention, by performing the original transformation of the Galois field, it is possible to perform the RS encoding on one field. As a result, it is possible to reduce the number of multiplier and reverse original arithmetic circuits, therefore the reduction in equipment size and cost of manufacturing can be attempted.
Also, according to the Reed Solomon **encoding** equipment and its functioning in embodiments of this invention, it can smoothly correspond to the alteration of the Galois field of the encoding target data.
Also, according to the Reed Solomon **decoding** equipment and its functioning in embodiments of this invention, by performing the original transformation of the Galois field, it is possible to perform the decoding of the RS encoding data on one Galois field. As a result, it is possible to reduce the number of multipliers and reverse original arithmetic circuits, therefore the reduction in equipment size and price of manufacturing can be attempted.
Also, according to the Reed Solomon **decoding** equipment and its operation in embodiments of this invention, it can smoothly correspond to the alteration of the Galois field of the encoding target data.

In view of the foregoing description it will be evident to a person skilled in the art that various modifications may be made within the scope of the invention.

The scope of the present disclosure includes any novel feature or combination of features disclosed therein either explicitly or implicitly or any generalisation thereof irrespective of whether or not it relates to the claimed invention or mitigates any or all of the problems addressed by the present invention. The applicant hereby gives notice that new claims may be formulated to such features during the prosecution of this application or of any such further application derived therefrom. In particular, with reference to the appended claims, features from dependent claims may be combined with those of the independent claims and features from respective independent claims may be combined in any appropriate manner and not merely in the specific combinations enumerated in the claims.

### [Brief explanation of diagrams]

### [Diagram 1]

Diagram 1 is the concept drawing of the RS encoding / decoding equipment which is related to the type of practical application of embodiments of this invention.

### [Diagram 2]

Diagram 2 shows the transformation table in regard to the input side transformation circuit and the output side transformation circuit, which are indicated in Diagram 1.

### [Diagram 3]

Diagram 3 is the composition drawing of the input side transformation circuit that is indicated in Diagram1.

### [Diagram 4]

Diagram 4 is the composition drawing of the output side transformation circuit that is indicated in Diagram1.

### [Diagram 5]

Diagram 5 is the composition drawing of the surplus arithmetic circuit that is used in the RS encoding core section, which is indicated in Diagram 1.

### [Diagram 6]

Diagram 6 is the composition drawing of the syndrome arithmetic circuit that is used in the RS decoding core section, which is indicated in Diagram 1.

### [Diagram 7]

Diagram 7 is the composition drawing of the division circuit that is used in the RS decoding core section, which is indicated in Diagram 1.

### [Diagram 8]

Diagram 8 is the composition drawing of the multiplier circuit that is used in the RS decoding core section, which is indicated in Diagram 1.

### [Diagram 9]

Diagram 9 is the composition drawing of the location detection (locator) circuit that is used in the RS decoding core section, which is indicated in Diagram 1.

### [Diagram 10]

Diagram 10 is the composition drawing of the evaluation value detection circuit that is used in the RS decoding core section, which is indicated in Diagram 1.

### [Diagram 11]

Diagram 11 is the concept drawing of the conventional RS encoding / decoding equipment.

### [Diagram 12]

Diagram 12 is the composition drawing of the surplus arithmetic circuit that is used in the RS encoding core section, which is indicated in the conventional diagram 11.

### [Diagram 13]

Diagram 13 is the composition drawing of the syndrome circuit that is used in the RS decoding core section, which is indicated in the conventional diagram 11.

### [Diagram 14]

Diagram 14 is the composition drawing of the division circuit that is used in the RS decoding core section, which is indicated in the conventional diagram 11.

### [Diagram 15]

Diagram 15 is the composition drawing of the multiplier circuit that is used in the RS decoding core section, which is indicated in the conventional diagram 11.

### [Diagram 16]

Diagram 16 is the composition drawing of the location detection (locator) circuit that is used in the RS decoding core section, which is indicated in the conventional diagram 11.

### [Diagram 17]

Diagram 17 is the composition drawing of the evaluation value detection circuit that is used in the RS decoding core section, which is indicated in the conventional diagram 11.

### [The explanation of the labels in the diagrams]

- 101: --- RS encoding / decoding equipment
- 102: --- Surplus arithmetic circuit
- 109: --- Syndrome arithmetic circuit
- 111: --- Multiplier coefficient memory section
- 112: --- RS encoding / decoding section
- 113: - 0 ∼ 113-L --- Multiplier
- 115: --- Reverse original arithmetic circuit
- 119: --- Output side transformation circuit
- 120: --- Parameter setting section
- 121: --- Division circuit of the polynomial expression
- 141: --- Multiplier circuit of the polynomial expression
- 151: --- Error location detection (locator) circuit
- 161: --- Evaluation value detection circuit

## Claims

1. An encoder for Reed Solomon encoding, comprising:
an encoding/decoding core for Galois field encoding input target data,
input transformation means for transforming encoded input target data into data of a prescribed Galois field,
output transformation means for reversibly transforming encoded data into data of a prescribed Galois field before tramsformation, and
a parameter setting section for outputting Galois field transformation parameters.
